# EUROPEAN PATENT APPLICATION

(11) **EP 4 750 230 A1**
(43) Date of publication of application: **27.05.2026**
(21) Application number: 25770915.4
(22) Date of filing: 02.09.2025
(51) Int. Cl.: H05K 1/14, H05K 1/11, H05K 3/00, H05K 5/02, H05K 7/20

(54) **PRINTED CIRCUIT BOARD ASSEMBLY DEFINING THROUGH-HOLE AND ELECTRONIC DEVICE COMPRISING SAME**

(30) Priority: 06.10.2024 KR 20240135281; 30.10.2024 KR 20240151452
(71) Applicant: SAMSUNG ELECTRONICS CO., LTD., Yeongtong-gu Suwon-si, Gyeonggi-do 16677 (KR)
(72) Inventor: PARK, Jeonggyun, Suwon-si, Gyeonggi-do 16677 (KR); OH, Junghoon, Suwon-si, Gyeonggi-do 16677 (KR); NA, Hyoseok, Suwon-si, Gyeonggi-do 16677 (KR); LEE, Pyeonghee, Suwon-si, Gyeonggi-do 16677 (KR); JU, Wanjae, Suwon-si, Gyeonggi-do 16677 (KR)
(74) Representative: HGF
(86) International application number: PCT/KR2025/013458
(87) International publication number: WO 2026/075377

(57) **Abstract**

An electronic device includes a first PCB, a second PCB, an interposer disposed between a first peripheral portion of the first PCB and a second peripheral portion of the second PCB, and one or more electronic components disposed in an internal space defined by a rear side of the first PCB, a front side of the second PCB, and an inner side of the interposer. The first PCB defines a first through hole positioned in the first peripheral portion, and the interposer defines a second through hole connected to the first through hole.

## Description

### [Technical Field]

The present disclosure relates to a printed circuit board assembly defining a through hole and an electronic device including the same.

### [Background Art]

An electronic device such as a smartphone may include a printed circuit board assembly on which various components are mounted. The printed circuit board assembly may include a plurality of printed circuit boards and an interposer connecting them to each other. The printed circuit board assembly may include a through hole. For example, the through hole may include at least one of an injection hole, an inspection hole, and a vent hole.

The above-described information may be provided as a related art for the purpose of helping understanding of the present disclosure. No argument or decision is made as to whether any of the above description may be applied as a prior art related to the present disclosure.

### [Disclosure]

### [Technical Solution]

An electronic device is described. The electronic device may comprise a first printed circuit board (PCB). The electronic device may comprise a second PCB spaced apart from the first PCB. The electronic device may comprise an interposer, disposed between a first peripheral portion of the first PCB and a second peripheral portion of the second PCB, configured to electrically connect the first PCB and the second PCB. The electronic device may comprise one or more electronic components disposed in an internal space that is defined by a rear side of the first PCB, a front side of the second PCB, and an inner side of the interposer. The first PCB may define a first through hole, extending from a front side of the first PCB to the rear side of the first PCB, positioned in the first peripheral portion of the first PCB. The interposer may define a second through hole extending from a position on the inner side of the interposer to the rear side of the first PCB to be connected to the first through hole of the first PCB.

A PCB assembly is described. The PCB assembly may comprise a first printed circuit board (PCB). The PCB assembly may comprise a second PCB spaced apart from the first PCB. The PCB assembly may comprise an interposer, disposed between a first peripheral portion of the first PCB and a second peripheral portion of the second PCB, configured to electrically connect the first PCB and the second PCB. The first PCB may define a first through hole, extending from a front side of the first PCB to the rear side of the first PCB, positioned in the first peripheral portion of the first PCB. The interposer may define a second through hole extending from a position on the inner side of the interposer to the rear side of the first PCB to be connected to the first through hole of the first PCB. An internal space of the PCB assembly defined by a rear side of the first PCB, a front side of the second PCB, and an inner side of the interposer is connected to outside of the PCB assembly, via the first through hole of the first PCB and the second through hole of the interposer.

### [Description of the Drawings]

FIG. 1 is a block diagram of an electronic device in a network environment according to various embodiments.
FIG. 2 illustrates an electronic device according to an embodiment.
FIG. 3 is an exploded perspective view of an electronic device according to an embodiment.
FIG. 4 illustrates an example of a printed circuit board assembly.
FIG. 5 is a cross-sectional view of a printed circuit board assembly cut along line A-A' of FIG. 4.
FIGS. 6 and 7 illustrate a printed circuit board assembly including a first through hole and a second through hole functioning as a vent hole.
FIG. 8 schematically illustrates the printed circuit board assembly of FIG. 6.
FIG. 9 schematically illustrates the printed circuit board assembly of FIG. 7.
FIG. 10 schematically illustrates a printed circuit board assembly according to an embodiment.
FIGS. 11, 12, 13, and 14 illustrate through holes of a printed circuit board assembly.
FIG. 15 illustrates a printed circuit board assembly including three printed circuit boards.
FIG. 16 illustrates a printed circuit board assembly including a first through hole and a second through hole functioning as an inspection hole.
FIG. 17 illustrates an assembly process of the printed circuit board assembly of FIG. 16.
FIG. 18 illustrates a printed circuit board assembly including a first through hole and a second through hole functioning as an inspection hole.
FIGS. 19 and 20 illustrate a printed circuit board assembly including a first through hole and a second through hole functioning as an injection hole.
FIGS. 21, 22, 23, and 24 illustrate a process of inspecting an injection amount of a thermal interface material using an inspection hole.
FIGS. 25, 26, 27, and 28 illustrate a process of inspecting an injection amount of a thermal interface material using an inspection hole.

### [Mode for Invention]

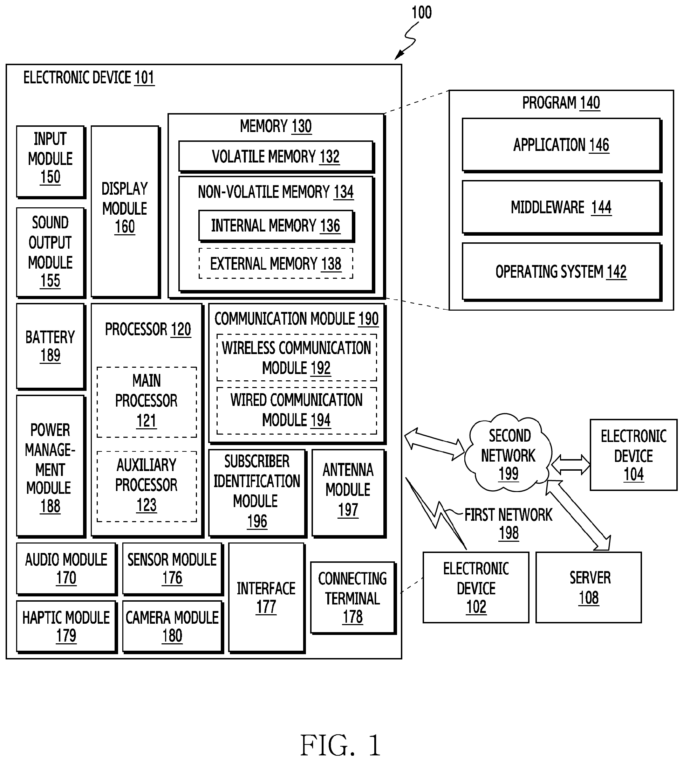

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element comprising a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

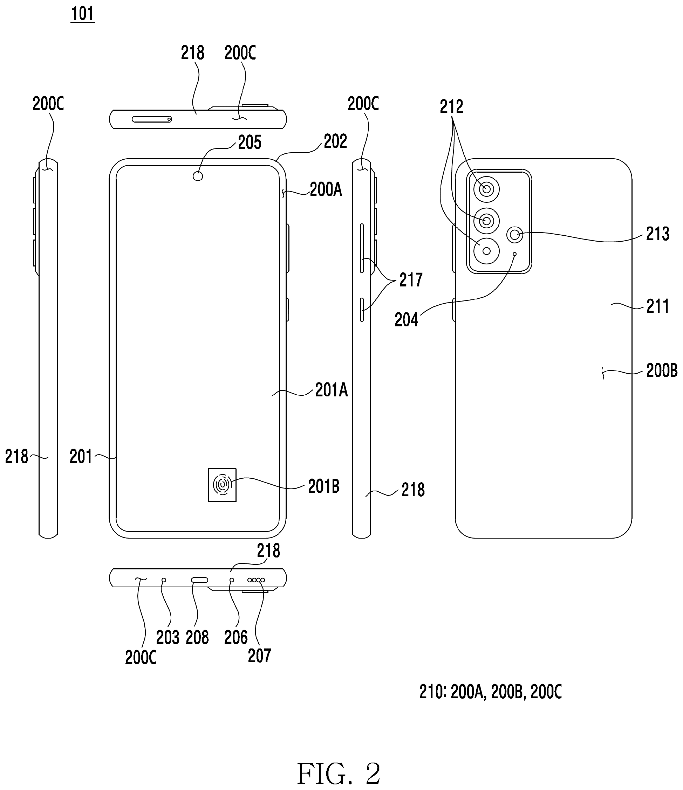

FIG. 2 illustrates an electronic device according to an embodiment.

Referring to FIG. 2, an electronic device 101 according to an embodiment may include a housing 210 forming an exterior of the electronic device 101. For example, the housing 210 may include a first side (or a front side) 200A, a second side (or a rear side) 200B, and a third side (or a lateral side) 200C surrounding a space between the first side 200A and the second side 200B.

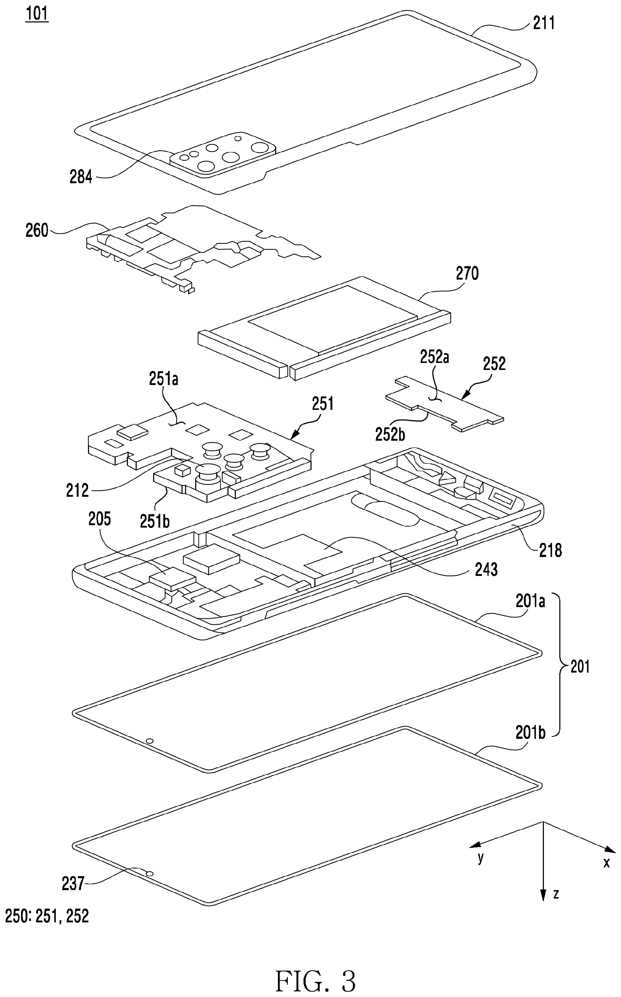

The electronic device 101 according to an embodiment may include a display (e.g., the display module 160 of FIG. 1). A display 201 may include a substantially transparent window (e.g., a window 201b of FIG. 3). The window 201b may form at least a portion of the first side 200A. For example, the window 201b may include a glass plate or a polymer plate including various coating layers, but is not limited thereto.

The electronic device 101 according to an embodiment may include a substantially opaque rear plate 211. According to an embodiment, the rear plate 211 may form at least a portion of the second side 200B. According to an embodiment, the rear plate 211 may be formed of coated or colored glass, ceramic, polymer, metal (e.g., aluminum, stainless steel (STS), or magnesium), or a combination of at least two of the materials.

The electronic device 101 according to an embodiment may include a frame 218. The frame 218 may form at least a portion of the third side 200C of the electronic device 101, by being coupled to the window 201b and/or the rear plate 211. For example, the frame 218 may entirely form the third side 200C of the electronic device 101. For example, the frame 218 may form the third side 200C of the electronic device 101 together with the window 201b and/or the rear plate 211.

The electronic device 101 according to an embodiment may include at least one of the display 201, audio modules 203, 204, and 207, a sensor module (not illustrated), camera modules 205, 212, and 213, a key input device 217, a light emitting element (not illustrated), and/or a connector hole 208. According to an embodiment, the electronic device 101 may omit at least one of the components (e.g., the key input device 217 or the light emitting element (not illustrated)), or may additionally include another component.

According to an embodiment, at least a portion of the display 201 may be visible via the window 201b forming the first side 200A. According to an embodiment, the display 201 may include a display panel (e.g., a display panel 201a of FIG. 3) disposed on a back side of the window 201b.

According to an embodiment, the display 201 may include a display region 201A. According to an embodiment, the display 201 may provide visual information to a user via the display region 201A.

According to an embodiment, the display region 201A may include a sensing region 201B configured to obtain biometric information of the user. Herein, a meaning of "the display region 201A includes the sensing region 201B" may be understood as that at least a portion of the sensing region 201B may be overlapped with the display region 201A. For example, the sensing region 201B may refer to a region capable of displaying visual information by the display 201 like another region of the display region 201A and capable of additionally obtaining the biometric information (e.g., fingerprint) of the user. According to an embodiment, the sensing region 201B may also be formed in the key input device 217.

According to an embodiment, the display 201 may include a region in which the first camera module 205 (e.g., the camera module 180 of FIG. 1) is positioned. According to an embodiment, an opening may be formed in the region of the display 201, and the first camera module 205 (e.g., a punch hole camera) may be at least partially disposed in the opening to face the first side 200A. For example, the display region 201A may surround at least a portion of a periphery of the opening. According to an embodiment, the first camera module 205 (e.g., an under display camera (UDC)) may be disposed below the display 201 so as to overlap the region of the display 201. For example, the display 201 may provide visual information to the user via the region, and additionally, the first camera module 205 may obtain an image corresponding to a direction toward the first side 200A via the region of the display 201.

According to an embodiment, the display 201 may be coupled or disposed adjacent to touch sensing circuitry, a pressure sensor capable of measuring an intensity (pressure) of a touch, and/or a digitizer that detects a magnetic field type stylus pen.

According to an embodiment, the audio modules 203, 204, and 207 (e.g., the audio module 170 of FIG. 1) may include the microphone holes 203 and 204 and/or the speaker hole 207.

According to an embodiment, the microphone holes 203 and 204 may include the first microphone hole 203 formed in a partial region of the third side 200C and/or the second microphone hole 204 formed in a partial region of the second side 200B. A microphone (not illustrated) for obtaining an external sound may be disposed in the microphone holes 203 and 204. The microphone may include a plurality of microphones to detect a direction of sound.

According to an embodiment, the second microphone hole 204 formed in the partial region of the second side 200B may be disposed adjacent to the camera modules 205, 212, and 213. For example, the second microphone hole 204 may obtain a sound according to an operation of the camera modules 205, 212, and 213. However, it is not limited thereto.

According to an embodiment, the speaker hole 207 may include the external speaker hole 207 and a call receiver hole (not illustrated). The external speaker hole 207 may be formed in a portion of the third side 200C of the electronic device 101. According to an embodiment, the external speaker hole 207 may be implemented as one hole with the microphone hole 203. Although not illustrated, the call receiver hole (not illustrated) may be formed in another portion of the third side 200C. For example, the call receiver hole may be formed on an opposite side of the external speaker hole 207 in the third side 200C. For example, based on an illustration of FIG. 2, the external speaker hole 207 may be formed on the third side 200C corresponding to a lower end of the electronic device 101, and the call receiver hole may be formed on the third side 200C corresponding to an upper end of the electronic device 101. However, it is not limited thereto, and according to an embodiment, the call receiver hole may be formed at a position other than the third side 200C. For example, the call receiver hole may be formed by a separated space between the display 201 and the frame 218.

According to an embodiment, the electronic device 101 may include at least one speaker (not illustrated) configured to output a sound to the outside of the housing 210 via the external speaker hole 207 and/or the call receiver hole (not illustrated).

According to an embodiment, the sensor module (not illustrated) (e.g., the sensor module 176 of FIG. 1) may generate an electrical signal or a data value corresponding to an internal operating state or an external environmental state of the electronic device 101. For example, the sensor module may include at least one of a proximity sensor, an HRM sensor, a fingerprint sensor, a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 205, 212, and 213 (e.g., the camera module 180 of FIG. 1) may include the first camera module 205 disposed to face the first side 200A of the electronic device 101, the second camera module 212 disposed to face the second side 200B, and a flash 213.

According to an embodiment, the second camera module 212 may include a plurality of cameras (e.g., a dual camera, a triple camera, or a quad camera). However, the second camera module 212 is not necessarily limited to including a plurality of cameras, and may include one camera.

According to an embodiment, the first camera module 205 and the second camera module 212 may include one or more lenses, an image sensor, and/or an image signal processor.

According to an embodiment, the flash 213 may include, for example, a light emitting diode or a xenon lamp. According to an embodiment, two or more lenses (an infrared camera and a wide-angle and telephoto lens) and image sensors may be disposed on one side of the electronic device 101.

According to an embodiment, the key input device 217 (e.g., the input module 150 of FIG. 1) may be disposed on the third side 200C of the electronic device 101. According to an embodiment, the electronic device 101 may not include a portion or all of the key input device 217, and the key input device 217 that is not included may be implemented in another form, such as a soft key, on the display 201.

According to an embodiment, the connector hole 208 may be formed on the third side 200C of the electronic device 101 to accommodate a connector of an external device. A connecting terminal (e.g., the connecting terminal 178 of FIG. 1) electrically connected to a connector of an external device may be disposed in the connector hole 208. The electronic device 101 according to an embodiment may include an interface module (e.g., the interface 177 of FIG. 1) for processing an electrical signal transmitted and received via the connecting terminal.

According to an embodiment, the frame 218 may include a vent hole 206. For example, air outside the housing 210 may be introduced into the inside of the housing 210 via the vent hole 206. For example, air inside the housing 210 may be discharged out of the outside of the housing 210 via the vent hole 206. A position of the vent hole 206 is not limited to a position illustrated in FIG. 2.

According to an embodiment, the electronic device 101 may include the light emitting element (not illustrated). For example, the light emitting element (not illustrated) may be disposed on the first side 200A of the housing 210. The light emitting element (not illustrated) may provide state information of the electronic device 101 in an optical form. According to an embodiment, the light emitting element (not illustrated) may provide a light source linked with an operation of the first camera module 205. For example, the light emitting element (not illustrated) may include an LED, an IR LED, and/or a xenon lamp.

FIG. 3 is an exploded perspective view of an electronic device according to an embodiment.

Hereinafter, an overlapping description of a configuration having the same reference numeral as the above-described configuration will be omitted.

Referring to FIG. 3, an electronic device 101 according to an embodiment may include a frame 218, a bracket 243, a printed circuit board assembly 250, a cover plate 260, and/or a battery 270. The printed circuit board assembly 250 may include a first printed circuit board assembly 251, which is a main board, and a second printed circuit board assembly 252, which is a sub-board.

According to an embodiment, the first printed circuit board assembly 251 and the second printed circuit board assembly 252 may be disposed on the bracket 243. For example, the first printed circuit board assembly 251 and the second printed circuit board assembly 252 may be disposed on a side (e.g., a side facing a -z direction) of the bracket 243. The first printed circuit board assembly 251 may include a first side 251a facing a rear side (e.g., the -z direction) of the electronic device 101 and a second side 251b facing a front side (e.g., a +z direction) of the electronic device 101. The first printed circuit board assembly 251 may be disposed on the bracket 243 so that the second side 251b faces the side of the bracket 243. The second printed circuit board assembly 252 may include a third side 252a facing the rear side of the electronic device 101 and a fourth side 252b facing the front side of the electronic device 101. The second printed circuit board assembly 252 may be disposed on the bracket 243 so that the fourth side 252b faces the side of the bracket 243. The second printed circuit board assembly 252 may be spaced apart from the first printed circuit board assembly 251.

The electronic device 101 according to an embodiment may include the frame 218 forming an exterior (e.g., the third side 200C of FIG. 2) of the electronic device 101 and the bracket 243 coupled to an internal side of the frame 218. According to an embodiment, the frame 218 and the bracket 243 may be disposed between a display 201 and a rear plate 211. For example, the frame 218 may surround a space between the rear plate 211 and the display 201. A window 201b may be attached to the frame 218.

According to an embodiment, the bracket 243 may support or accommodate other components included in the electronic device 101. For example, the display 201 may be disposed on a side of the bracket 243 facing a direction (e.g., the +z direction), and a portion of the display 201 may be supported by the bracket 243. For example, the first printed circuit board assembly 251, the second printed circuit board assembly 252, the battery 270, and a second camera module 212 may be disposed on another side of the bracket 243 facing a direction (e.g., the -z direction) opposite to the direction. For example, the first printed circuit board assembly 251, the second printed circuit board assembly 252, the battery 270, and the second camera module 212 may each be seated in a recess defined by the frame 218 and/or the bracket 243.

According to an embodiment, the first printed circuit board assembly 251, the second printed circuit board assembly 252, and the battery 270 may be coupled to the bracket 243, respectively. For example, the first printed circuit board assembly 251 and the second printed circuit board assembly 252 may be fixedly disposed in the bracket 243 via a coupling member such as a screw. For example, the battery 270 may be fixedly disposed in the bracket 243 via an adhesive member (e.g., a double-sided tape). However, it is not limited by the above-described example.

According to an embodiment, the cover plate 260 may be disposed between the first printed circuit board assembly 251 and the rear plate 211. According to an embodiment, the cover plate 260 may be disposed on the first printed circuit board assembly 251. For example, the cover plate 260 may be disposed on a side of the first printed circuit board assembly 251 facing the -z direction.

According to an embodiment, the cover plate 260 may at least partially overlap the first printed circuit board assembly 251 based on a z-axis. According to an embodiment, the cover plate 260 may cover at least a partial region of the first printed circuit board assembly 251. Through this, the cover plate 260 may protect the first printed circuit board assembly 251 from a physical impact or prevent detachment of a connector coupled to the first printed circuit board assembly 251.

According to an embodiment, the cover plate 260 may be fixedly disposed in the first printed circuit board assembly 251 via a coupling member (e.g., a screw), or may be coupled to the bracket 243 together with the first printed circuit board assembly 251 via the coupling member.

According to an embodiment, the display 201 may be disposed between the bracket 243 and the window 201b. For example, the window 201b may be disposed in a side (e.g., the +z direction) of a display panel 201a, and the bracket 243 may be disposed in another side (e.g., the - z direction).

According to an embodiment, the window 201b may be coupled to the display panel 201a. For example, the window 201b and the display panel 201a may be adhered to each other via an optical adhesive member (e.g., optically clear adhesive (OCA) or optically clear resin (OCR)) interposed therebetween.

According to an embodiment, the window 201b may be coupled to the frame 218. For example, when viewed in a z-axis direction, the window 201b may include an outer portion extending outside the display 201, and may be adhered to the frame 218 via an adhesive member (e.g., a waterproof tape) disposed between the frame 218 and the outer portion of the window 201b. However, it is not limited by the above-described example.

According to an embodiment, a processor (e.g., the processor 120 of FIG. 1), memory (e.g., the memory 130 of FIG. 1), and/or an interface (e.g., the interface 177 of FIG. 1) may be disposed in the first printed circuit board assembly 251 and/or the second printed circuit board assembly 252. The processor may include, for example, one or more of a central processing unit, an application processor, a graphic processing unit, an image signal processor, a sensor hub processor, or a communication processor. The memory may include, for example, volatile memory or non-volatile memory. The interface may include, for example, a high definition multimedia interface (HDMI), a universal serial bus (USB) interface, an SD card interface, and/or an audio interface. The interface may electrically or physically connect the electronic device 101 to an external electronic device, and may include a USB connector, an SD card/MMC connector, or an audio connector. According to an embodiment, the first printed circuit board assembly 251 and the second printed circuit board assembly 252 may be operably or electrically connected to each other via a connecting member (e.g., a flexible printed circuit board).

According to an embodiment, the battery 270 (e.g., the battery 189 of FIG. 1) may supply power to at least one component of the electronic device 101. For example, the battery 270 may include a rechargeable secondary battery or a fuel cell. At least a portion of the battery 270 may be disposed on substantially the same plane as the first printed circuit board assembly 251 and/or the second printed circuit board assembly 252.

The electronic device 101 according to an embodiment may include an antenna module (not illustrated) (e.g., the antenna module 197 of FIG. 1). According to an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power with an external device.

According to an embodiment, a first camera module 205 (e.g., a front camera) may be disposed in at least a portion of the bracket 243 so that a lens may receive external light via a partial region (e.g., a camera region 237) of the window 201b (e.g., the front side 200A of FIG. 2).

According to an embodiment, a second camera module 212 (e.g., a rear camera) may be disposed between the bracket 243 and the rear plate 211. According to an embodiment, the second camera module 212 may be electrically connected to the first printed circuit board assembly 251 via a connecting member (e.g., a connector). According to an embodiment, the second camera module 212 may be disposed so that a lens may receive external light via a camera region 284 of the rear plate 211 of the electronic device 101.

According to an embodiment, the camera region 284 may be formed on a surface (e.g., the rear side 200B of FIG. 2) of the rear plate 211. According to an embodiment, the camera region 284 may be formed at least partially transparent so that external light may be incident on a lens of the second camera module 212. According to an embodiment, at least a portion of the camera region 284 may protrude from the surface of the rear plate 211 to a predetermined height. However, it is not limited thereto, and according to an embodiment, the camera region 284 may form substantially the same plane as the surface of the rear plate 211.

According to an embodiment, a housing 210 of the electronic device 101 may mean a configuration or a structure forming at least a portion of the exterior of the electronic device 101. In this regard, at least a portion of the window 201b, the frame 218, the bracket 243, and/or the rear plate 211 forming the exterior of the electronic device 101 may be referred to as the housing 210 of the electronic device 101.

The electronic device 101 according to an embodiment may include the rear plate 211. The rear plate 211 may define at least a portion of the rear side (e.g., the second side 200B of FIG. 2) of the electronic device 101. The rear plate 211 may be referred to as a rear cover or a back cover in terms of defining at least a portion of the rear side of the electronic device 101. For example, the rear plate 211 may be opposite to a display (or the window 201b of the display) that forms at least a portion of the front side (e.g., the first side 200A of FIG. 2) of the electronic device 101. The window 201b of the display 201 may form at least a portion of the front side of the electronic device 101, and the rear plate 211 may form at least a portion of the rear side of the electronic device 101. The display may face substantially in the +z direction, and the rear plate 211 may face substantially in the -z direction.

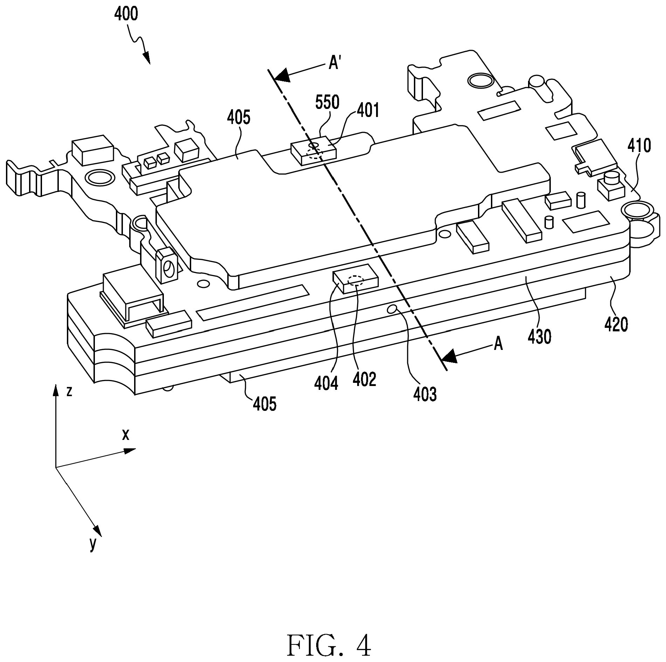

Hereinafter, a structure of a printed circuit board assembly (e.g., a printed circuit board assembly 400 of FIG. 4) according to an embodiment will be described with reference to the drawings. Terms "above" and "below" used in the present disclosure are used as terms indicating a relative position between components, other than terms indicating an absolute position. For example, in a case that the printed circuit board assembly 400 illustrated in the drawing is flipped, "above" and "below" may be interchanged.

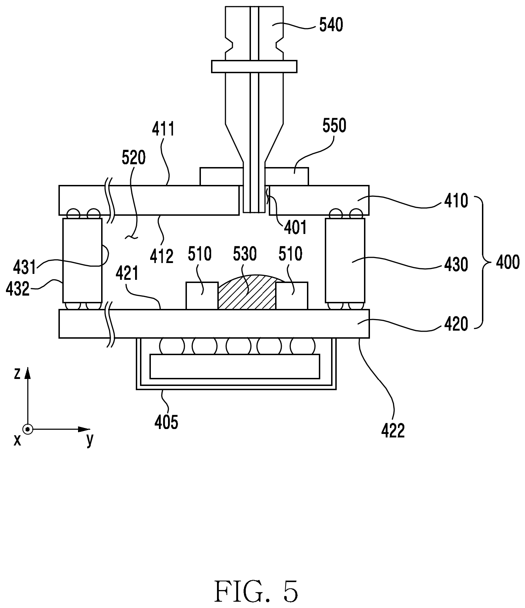

FIG. 4 illustrates an example of a printed circuit board assembly. FIG. 5 is a cross-sectional view of a printed circuit board assembly cut along line A-A' of FIG. 4.

Referring to FIG. 4, the above-described printed circuit board assembly (e.g., the printed circuit board assembly 250 of FIG. 3), e.g. as may be taken in isolation from the other components/parts of electronic device 101 illustrated in FIG. 3, may include a printed circuit board assembly 400 in which a plurality of printed circuit boards are stacked. In FIG. 4, the printed circuit board assembly 400 is illustrated as including a first printed circuit board 410 and a second printed circuit board 420, but the printed circuit board assembly 400 according to the present disclosure is not limited thereto. For example, the printed circuit board assembly 400 may include three or more printed circuit boards.

The printed circuit board assembly 400 according to an embodiment may include the first printed circuit board 410, the second printed circuit board 420, and an interposer 430 (or, more generally, a connection means, connector, joining element, spacing element, intermediate layer, bridge, or portion). The interposer 430 may be configured to physically (e.g. mechanically) and electrically connect the first printed circuit board 410 and the second printed circuit board 420 by being disposed between the first printed circuit board 410 and the second printed circuit board 420.

According to an embodiment, the first printed circuit board 410 may be spaced apart from the second printed circuit board 420. For example, the first printed circuit board 410 may be disposed above (e.g., a +z direction, referring to the x, y and z axis directions shown in FIG. 4) the second printed circuit board 420. The interposer 430 may be disposed between the first printed circuit board 410 and the second printed circuit board 420. For example, the interposer 430 may be disposed along or in a space (or region, void, volume etc.) between a peripheral portion (e.g., a first peripheral portion) of the first printed circuit board 410 and a peripheral portion (e.g., a second peripheral portion) of the second printed circuit board 420. The peripheral portion of a printed circuit board many be regarded as a portion around or adjacent to the edge, rim or periphery of the printed circuit board, which may extend inwards from the absolute edge of the printed circuit board by a small amount. The interposer 430 may be configured to provide an electrical connection between the first printed circuit board 410 and the second printed circuit board 420.

According to an embodiment, a shield can 405 may be disposed on the first printed circuit board 410 and/or the second printed circuit board 420. For example, the shield can 405 may shield an electromagnetic wave generated when an electronic component operates by covering the electronic component disposed on the first printed circuit board 410 and/or the second printed circuit board 420. For example, the shield can 405 may cover the electronic component so that an electromagnetic wave emitted from the electronic component does not affect another electronic component or an electromagnetic wave emitted from the other electronic component does not affect the electronic component. Since the electronic component is covered by the shield can 405, interference by the electromagnetic wave may be reduced.

According to an embodiment, an internal space or internal volume (e.g., an internal space 520 of FIG. 5) of the printed circuit board assembly 400 may be formed by the first printed circuit board 410, the second printed circuit board 420, and the interposer 430. The internal space is alternatively referred to as an internal volume.

Referring to FIG. 5, the internal space 520 of the printed circuit board assembly 400 surrounded by the first printed circuit board 410, the second printed circuit board 420, and the interposer 430 may be formed. The internal space 520 of the printed circuit board assembly 400 may be defined by a rear side 412 of the first printed circuit board 410, a front side 421 of the second printed circuit board 420, and an inner side 431 of the interposer 430. The internal space 520 of the printed circuit board assembly 400 may instead or also be considered defined by inner sides of the first printed circuit board 410, the second printed circuit board 420, and the interposer 430. One or more electronic components 510 may be disposed or provided in the internal space 520 of the printed circuit board assembly 400. For example, the one or more electronic components 510 disposed on the rear side 412 of the first printed circuit board 410 and/or the front side 421 of the second printed circuit board 420 may be positioned in the internal space 520 of the printed circuit board assembly 400. The printed circuit board assembly 400 having a structure in which the first printed circuit board 410 and the second printed circuit board 420 are stacked may have a high degree of integration, as various electronic components may be disposed.

According to an embodiment, a front side 411 (or outer side) of the first printed circuit board 410, a rear side 422 (or outer side) of the second printed circuit board 420, and an outer side 432 of the interposer 430 may define an outer side of the printed circuit board assembly 400. For example, the front side 411 of the first printed circuit board 410 may define at least a portion of a front side of the printed circuit board assembly 400. For example, the rear side 422 of the second printed circuit board 420 may define at least a portion of a rear side of the printed circuit board assembly 400. For example, the outer side 432 of the interposer 430 may define at least a portion of a lateral side of the printed circuit board assembly 400.

According to an embodiment, a thermal interface material 530, or TIM, may be included in the internal space 520 of the printed circuit board assembly 400. For example, at least a portion or region of the internal space 520 may be filled with the thermal interface material 530. Heat generated from the one or more electronic components 510 positioned in the internal space 520 may be diffused via the thermal interface material 530. The thermal interface material 530 may be injected into the internal space 520 after the printed circuit board assembly 400 is manufactured.

According to an embodiment, at least one of the first printed circuit board 410 and the second printed circuit board 420 may include an injection hole 401 for injecting or inserting a nozzle 540 for injecting (or providing) the thermal interface material 530. In FIG. 5, the injection hole 401 of the printed circuit board assembly 400 is illustrated to be formed on the first printed circuit board 410, but the present disclosure is not limited thereto. For example, the injection hole 401 may be formed on the second printed circuit board 420. The injection hole 401 may be at least partially covered by a damper pad 550. The damper pad 550 may include a cut groove into which the nozzle 540 for injecting the thermal interface material 530 may be inserted. The nozzle 540 may be inserted into the injection hole 401 by passing through the damper pad 550 while pushing the cut groove, that is, the nozzle 540 may be forced through the cut groove such that the cut groove widens to allow for passage of the nozzle 540. The nozzle 540 inserted into the injection hole 401 may discharge or inject the thermal interface material 530 into the internal space 520 of the printed circuit board assembly 400. The damper pad 550 may guide a position of the nozzle 540 and may prevent and/or reduce the thermal interface material 530 from flowing back via the injection hole 401.

Referring back to FIG. 4, the printed circuit board assembly 400 may include an inspection hole 402. For example, the first printed circuit board 410 and/or the second printed circuit board 420 may include the inspection hole 402 for inspecting an injection state of the thermal interface material 530. For example, the inspection hole 402 may be used to inspect the injection state, such as an injection amount and/or an injection position (or resting position) of the thermal interface material 530. When the thermal interface material 530 is discharged from a nozzle (e.g., the nozzle 540 of FIG. 5), the thermal interface material 530 may at least partially fill the internal space (e.g., the internal space 520 of FIG. 5) of the printed circuit board assembly 400. The thermal interface material 530 injected into the internal space 520 may be visible from the outside of the printed circuit board assembly 400 via the inspection hole 402. The inspection hole 402 may be covered by a cap 404. For example, the cap 404 may include a substantially transparent material so that the inspection hole 402 covered by the cap 404 may be visible. The cap 404 may prevent and/or reduce a thermal interface material 530 from being discharged to the outside via the inspection hole 402.

According to an embodiment, the printed circuit board assembly 400 may include a vent hole 403. For example, the vent hole 403 may prevent and/or reduce delamination of layers of the printed circuit board assembly 400 by high internal pressure by providing a path through which gas in the internal space 520 of the printed circuit board assembly 400 is discharged to the outside of the printed circuit board assembly 400, and may prevent and/or reduce corrosion of the printed circuit board assembly 400 by high humidity by providing a path through which moisture in the internal space 520 is discharged to the outside of the printed circuit board assembly 400. Heat generated when one or more electronic components (e.g., the one or more electronic components 510 of FIG. 5) positioned in the internal space 520 operate may be diffused to the outside of the printed circuit board assembly 400 via the vent hole 403.

As described above, since the printed circuit board assembly 400 includes the injection hole 401, the inspection hole 402, and the vent hole 403, a design limitation of the printed circuit board assembly 400 may be caused. For example, the one or more electronic components 510 may be disposed to be spaced apart from a partial region (or portion, area etc.) of the front side 421 of the second printed circuit board 420 facing the injection hole 401 by a certain distance or more so that the one or more electronic components 510 positioned in the internal space 520 of the printed circuit board assembly 400 are not damaged by the nozzle 540 inserted via the injection hole 401, that is, are not damaged when the nozzle 540 is inserted. Since a disposition of the one or more electronic components 510 is limited (e.g. there are limited arrangements of the one or more electronic components 510 and limited space in which to dispose the one or more electronic components 510), mounting of the electronic components may be difficult and the number of the one or more electronic components 510 disposed in the internal space 520 may be reduced. Since it is impossible to dispose the electronic components in a region in which the injection hole 401, the inspection hole 402, and the vent hole 403 are formed, an area of the printed circuit board assembly 400 in which the electronic components may be disposed may be reduced (or, to put another way, a size of a working area of the printed circuit board assembly 400 is reduced through the provision of the injection hole 401, the inspection hole 402, and/or the vent hole 403).

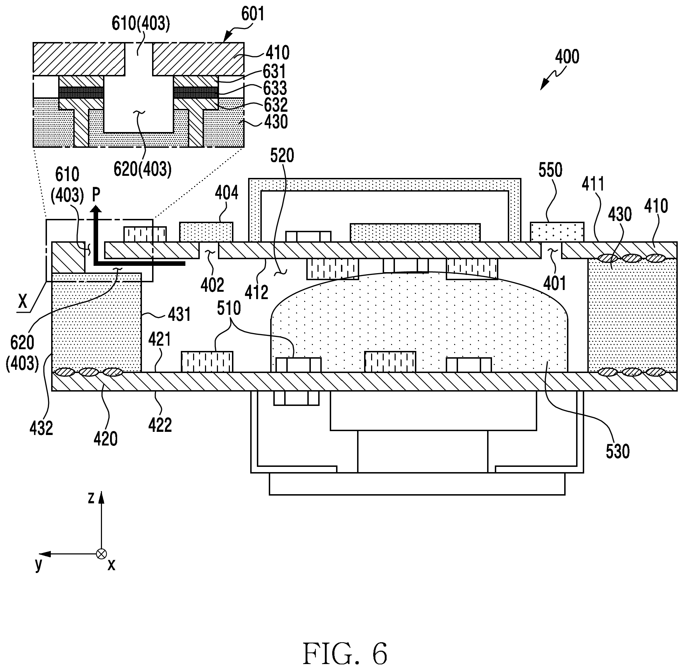

The printed circuit board assembly 400 according to an embodiment described below may include a through hole (e.g., a second through hole 620 of FIG. 6) formed in the interposer 430 (e.g. formed at least partially in or through the interposer 430, or in a region between the interposer 430 and the first printed circuit board 410). As an example, as illustrated in FIG. 4, the vent hole 403 may be formed in the interposer 430. The second through hole 620 may be formed by removing a portion of the interposer 430. The first printed circuit board 410 and/or the second printed circuit board 420 may include a through hole (e.g., a first through hole 610 of FIG. 6) connected to the second through hole 620 of the interposer 430. The first through hole 610 may be formed in the first peripheral portion of the first printed circuit board 410 or the second peripheral portion of the second printed circuit board 420 so as to be connected to the second through hole 620. For example, the first through hole 610 and the second through hole 620 may be connected or joined in a region or space outside of the internal space 520 or in the removed portion of the interposer 430 (that is, in the space from which the portion of the interposer 430 was removed to form the second through hole 620). For example, the second through hole 620 may lead or connect directly to the first through hole 610 opened or provided in the first printed circuit board 410 or the second printed circuit board 420. Since the first peripheral portion of the first printed circuit board 410 and the second peripheral portion of the second printed circuit board 420 are in contact with the interposer 430, an electronic component may not be disposed on the first peripheral portion and the second peripheral portion. Since the first through hole 610 formed in the first peripheral portion and the second peripheral portion in which an electronic component may not be disposed is connected to the internal space 520 of the printed circuit board assembly 400 via the interposer 430 without reducing the area of the printed circuit board assembly 400 for disposing an electronic component, a disposition of the one or more electronic components 510 disposed in the internal space 520 of the printed circuit board assembly 400 may be free and the greater number of the one or more electronic components 510 may be disposed in the printed circuit board assembly 400. That is, by forming the first through hole 610 in a region between the first peripheral portion or the second peripheral portion and using it as, e.g., the vent hole 403, the area of the printed circuit board assembly 400 for disposing an electronic component is greater than in a case where the vent hole 403 is formed in relation to a region of the first or second printed circuit boards 410, 420 other than region between the first and second peripheral portions. As a result, there is more space or area within the printed circuit board assembly 400 for disposing electronic components 510. In the present disclosure, the expression "includes a through hole" may be replaced with "defines or forms a through hole". For example, the first printed circuit board may define a first through hole, and the second printed circuit board may define a second through hole.

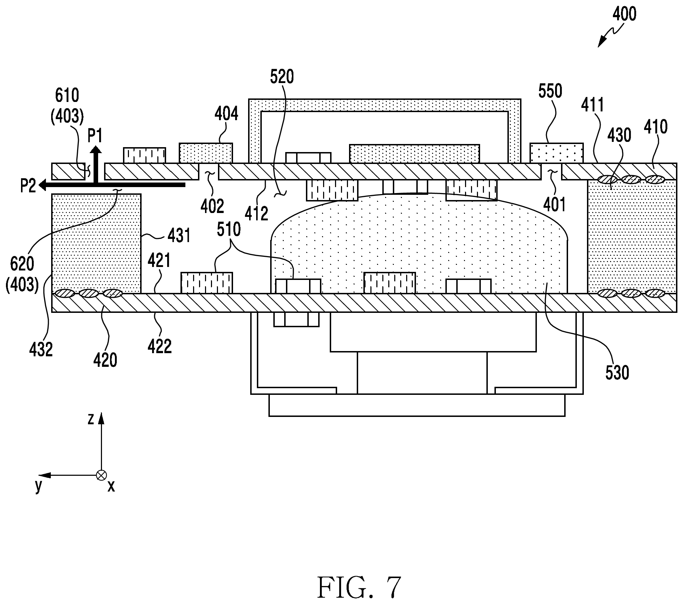

FIGS. 6 and 7 illustrate a printed circuit board assembly including a first through hole and a second through hole functioning as a vent hole.

Referring to FIG. 6, a printed circuit board assembly 400 according to an embodiment may include a first printed circuit board 410 including a first through hole 610, a second printed circuit board 420 disposed below (e.g., in a -z direction) the first printed circuit board 410, and an interposer 430 including a second through hole 620. As described above, the interposer 430 may be disposed between a peripheral portion (e.g., a first peripheral portion) of the first printed circuit board 410 and a peripheral portion (e.g., a second peripheral portion) of the second printed circuit board 420 (or between the edges of the first and second printed circuit boards 410, 420).

According to an embodiment, the first through hole 610 of the first printed circuit board 410 may be formed by penetrating the first printed circuit board 410 in a thickness direction (e.g., a first direction) of the first printed circuit board 410. For example, the first through hole 610 may extend from a front side 411 of the first printed circuit board 410 to a rear side 412 of the first printed circuit board 410. The first direction may be referred to as the -z direction of FIG. 6. According to an embodiment, the first through hole 610 may be positioned in the first peripheral portion, e.g. in a region of the first print circuit board 410 above the interposer 430, when the second printed circuit board 420 is regarded as disposed below the first printed circuit board 410. Since the first peripheral portion is connected to the interposer 430, the first through hole 610 disposed in the first peripheral portion may overlap the interposer 430. For example, when the first printed circuit board 410 is viewed from above (e.g., when viewing in the -z direction), the first through hole 610 may overlap the interposer 430. Since the first peripheral portion is a portion in which an electronic component may not be disposed, an area of the first printed circuit board 410 for disposing the electronic component may not be reduced in a case (i.e. if or when) that the first through hole 610 is formed in the first peripheral portion.

According to an embodiment, the second through hole 620 of the interposer 430 may be formed in a width direction (e.g., a second direction) of the interposer 430. The second direction may be referred to as a -y direction of FIG. 6. For example, the second through hole 620 may be formed at least partially between the rear side 412 of the first printed circuit board 410 and a portion of the interposer 430. The second direction may be perpendicular or substantially perpendicular to the first direction.

For example, referring to an enlarged view 601 of an X region of FIG. 6 in which the first through hole 610 and the second through hole 620 are connected, the interposer 430 may include a second conductive pad 632 electrically connected to a first conductive pad 631 of the first printed circuit board 410. The second conductive pad 632 may be electrically connected by a solder 633 between the first conductive pad 631 and the second conductive pad 632. According to an embodiment, the second through hole 620 may be formed by omitting (or removing) the second conductive pad 632 and the solder 633 in a portion of the interposer 430. However, embodiments of the present disclosure are not limited thereto. For example, the second through hole 620 may be formed by removing the second conductive pad 632 and the solder 633 and drilling a portion of the interposer 430. The enlarged view 601 indicates the X region in a case that the X region is viewed from a front (e.g., in a case of viewing in a +x direction); that is, the enlarged view 601 shows a cross section through the first through hole 610 and the second through hole 620 in the x direction of FIG. 6.

According to an embodiment, the second through hole 620 of the interposer 430 may be connected or joined to the first through hole 610 of the first printed circuit board 410. The second through hole 620 of the interposer 430 may extend from a position on an inner side 431 of the interposer 430 defining an internal space 520 of the printed circuit board assembly 400 to a position facing the first through hole 610 of the first printed circuit board 410. The position facing the first through hole 610 may be positioned between the inner side 431 of the interposer 430 and an outer side 432 of the interposer 430.

According to an embodiment, the first through hole 610 of the first printed circuit board 410 and the second through hole 620 of the interposer 430 may be configured to function as a vent hole 403 through which air in the internal space 520 of the printed circuit board assembly 400 is discharged. For example, the internal space 520 may be connected to the outside of the printed circuit board assembly 400 via the second through hole 620 and the first through hole 610. The air in the internal space 520 may be discharged to the outside of the printed circuit board assembly 400 via the second through hole 620 and the first through hole 610. The first through hole 610 and the second through hole 620 may be configured to provide an airflow path P through which the air in the internal space 520 of the printed circuit board assembly 400 flows to the outside of the printed circuit board assembly 400. Any air flowing to the outside of the printed circuit board assembly 400 through the first through hole 410 first passes through the second through hole 420. The printed circuit board assembly 400 according to an embodiment may include an injection hole 401 and an inspection hole 402 in addition to the vent hole 403. For example, the first printed circuit board 410 may include the injection hole 401 and the inspection hole 402. For example, a damper pad 550 for covering the injection hole 401 may be disposed on the front side 411 of the first printed circuit board 410. For example, a cap 404 for covering the inspection hole 402 may be disposed on the front side 411 of the first printed circuit board 410.

According to an embodiment, as the first through hole 610 forming a portion of the vent hole 403 is positioned in the first peripheral portion of the first printed circuit board 410 overlapping the interposer 430, a reduction in an area in which electronic components may be disposed by the vent hole 403 may not be caused, i.e. forming the vent hole in this manner means an area in which electronic components may be disposed in the internal space 520 of the printed circuit board assembly 400 may not be reduced due to the provision of the vent hole. As the second through hole 620 is formed between the rear side 412 of the first printed circuit board 410 and a portion of the interposer 430, the first through hole 610 may be connected to the internal space 520 of the printed circuit board assembly 400 via the second through hole 620. As the first through hole 610 positioned in the first peripheral portion is connected to the internal space 520 of the printed circuit board assembly 400 via the second through hole 620, the first through hole 610 may be configured to function as the vent hole 403.

According to an embodiment, as the second through hole 620 forming another portion of the vent hole 403 is formed by omitting the second conductive pad 632 and the solder 633 of a portion of the interposer and/or drilling a portion of the interposer 430, a manufacturing process may be simple and easy.

In FIG. 6, the second through hole 620 is illustrated to extend from the inner side 431 of the interposer 430 to a point between the inner side 431 of the interposer 430 and the outer side 432 of the interposer 430, but embodiments of the present disclosure are not limited thereto.

Referring to FIG. 7, the second through hole 620 may extend from the inner side 431 of the interposer 430 to the outer side 432 of the interposer 430. For example, the second through hole 620 may be formed by laterally penetrating the interposer 430. For example, the second through hole 620 may be an opening in a sidewall, or external sidewall, of the interposer 430. For example, the second through hole 620 may be formed between the rear side 412 of the first printed circuit board 410 and a portion of the interposer 430.

According to an embodiment, as the second through hole 620 of the interposer 430 extends from the inner side 431 of the interposer 430 to the outer side 432 of the interposer 430, the second through hole 620 may connect the internal space 520 of the printed circuit board assembly 400 to the outside of the printed circuit board assembly 400. As illustrated in FIG. 7, an airflow path through which the air in the internal space 520 of the printed circuit board assembly 400 flows to the outside of the printed circuit board assembly 400 may include a first airflow path P1 formed by a portion of the second through hole 620 and the first through hole 610 and a second airflow path P2 formed by the second through hole 620. The first airflow path P1 may correspond to the airflow path (e.g., the airflow path P of FIG. 6) of FIG. 6. The description of the first airflow path P1 may be the same as the description of the airflow path P of FIG. 6. The interaction(s) between the first through hole 610 and the second through hole 620, at least between the inner side 431 of the interposer 430 and the location where the second through hole 620 connects to the first through hole 610, may be the same as described for the first through hole 610 and the second through hole 620 in FIG. 6.

According to an embodiment, as the second airflow path P2 may be formed in a case that the second through hole 620 extends from the inner side 431 of the interposer 430 to the outer side 432 of the interposer 430, air may be smoothly discharged from the internal space 520 of the printed circuit board assembly 400. For example, according to a size, a thickness and a purpose of the printed circuit board assembly 400, the number of one or more electronic components 510 disposed in the internal space 520, or an environment in which the printed circuit board assembly 400 is used, a relatively large amount of air discharge may be required. According to the factors, in a case of the printed circuit board assembly 400 requiring a relatively large amount of air discharge, the second through hole 620 extending from the inner side 431 of the interposer 430 to the outer side 432 of the interposer 430 may be included. As the second airflow path P2 may be formed by the second through hole 620, air discharge by the first airflow path P1 and the second airflow path P2 may be smoothly performed.

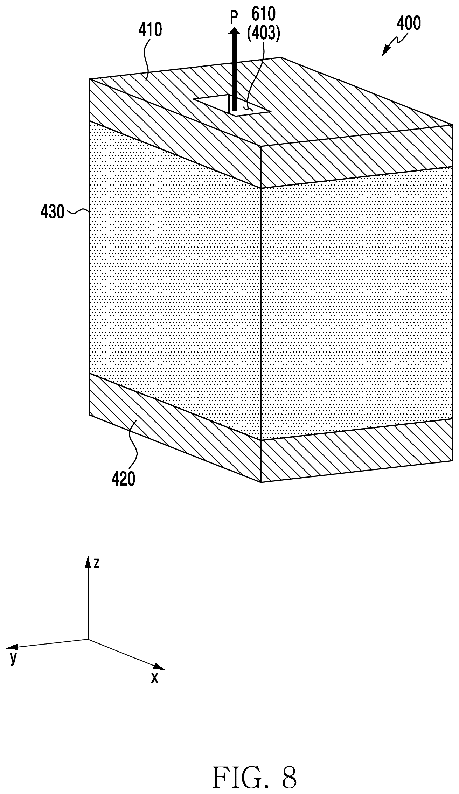

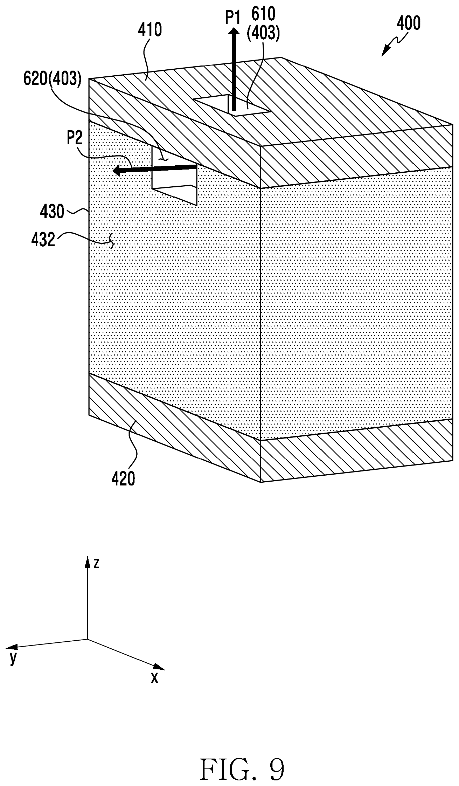

FIG. 8 schematically illustrates the printed circuit board assembly of FIG. 6. FIG. 9 schematically illustrates the printed circuit board assembly of FIG. 7.

Referring to FIG. 8, a printed circuit board assembly 400 may include a first through hole 610 and a second through hole (e.g., the second through hole 620 of FIG. 6) functioning as a vent hole 403. In a case of an example illustrated in FIG. 8, since the second through hole 620 extends from an inner side (e.g., the inner side 431 of FIG. 6) of an interposer 430 to a point of the interposer 430 overlapping the first through hole 610, the second through hole 620 may not be visible from the outside of the printed circuit board assembly 400.

According to an embodiment, an airflow path P of air discharged from an internal space (e.g., the internal space 520 of FIG. 6) of the printed circuit board assembly 400 to the outside of the printed circuit board assembly 400 may be formed by the first through hole 610 and the second through hole 620. The air in the internal space 520 may be discharged to the outside of the printed circuit board assembly 400 by passing through the second through hole 620 and the first through hole 610. As described above, since the first through hole 610 is formed in a portion in which electronic components may not be disposed as the first through hole 610 is positioned in a first peripheral portion of the first printed circuit board 410 overlapping the interposer 430, the vent hole 403 may be provided without reducing an area of the first printed circuit board 410 in which the electronic components may be disposed.

Referring to FIG. 9, the printed circuit board assembly 400 may include the first through hole 610 and the second through hole (e.g., the second through hole 620 of FIG. 7) functioning as the vent hole 403. In a case of an example illustrated in FIG. 9, since the second through hole 620 extends from the inner side (e.g., the inner side 431 of FIG. 7) of the interposer 430 to an outer side 432 of the interposer 430, the second through hole 620 may be visible from the outside of the printed circuit board assembly 400. The second through hole 620 may connect the internal space (e.g., the internal space 520 of FIG. 7) of the printed circuit board assembly 400 to the outside of the printed circuit board assembly 400.

According to an embodiment, an airflow path of air discharged from the internal space 520 of the printed circuit board assembly 400 to the outside of a printed circuit board may include a first airflow path P1 formed by the first through hole 610 and the second through hole 620 and a second airflow path P2 formed by the second through hole 620. The air in the internal space 520 may pass through the second through hole 620 and the first through hole 610, pass through the first airflow path P1 discharged to the outside of the printed circuit board assembly 400 and the second through hole 620, and be discharged along the second airflow path P2 discharged to the outside of the printed circuit board assembly 400. As described above, as the second airflow path P2 may be additionally formed by the second through hole 620 exposed to the outer side 432 of the interposer 430, air discharge in the internal space 520 may be smoother.

The printed circuit board assembly 400 illustrated in FIGS. 8 and 9 is illustrated as a structure using the first through hole 610 of the first printed circuit board 410 and the second through hole 620 of the interposer 430 formed between a rear side 412 of the first printed circuit board 410 and a portion of the interposer 430 as the vent hole 403, but embodiments of the present disclosure are not limited thereto.

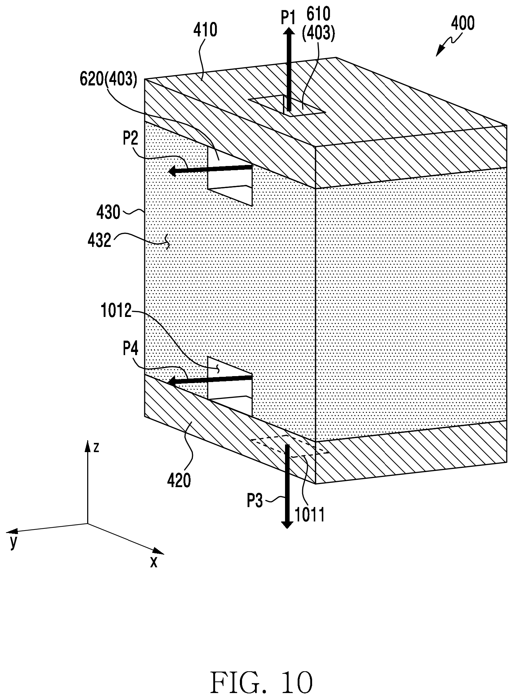

FIG. 10 schematically illustrates a printed circuit board assembly according to an embodiment.

Referring to FIG. 10, a second printed circuit board 420 may further include a third through hole 1011 configured to function as a vent hole 403. The third through hole 1011 may be positioned in a second peripheral portion of the second printed circuit board 420 in contact with an interposer 430. According to an embodiment, the interposer 430 may further include a fourth through hole 1012 connected to the third through hole 1011 of the second printed circuit board 420. For example, the fourth through hole 1012 may extend another position of the inner side 431 of the interposer 430 to the front side 421 of the second printed circuit board 420 to be connected to the third through hole 1011 of the second printed circuit board 420. Air in an internal space (e.g., the internal space 520 of FIG. 6) of a printed circuit board assembly 400 may be discharged to the outside of the printed circuit board assembly 400 via a third airflow path P3 formed along the fourth through hole 1012 of the interposer 430 and the third through hole 1011 of the second printed circuit board 420. In a case that the fourth through hole 1012 of the interposer 430 extends from an inner side (e.g., the inner side 431 of FIG. 6) of the interposer 430 to an outer side 432 of the interposer 430, a fourth airflow path P4 formed by the fourth through hole 1012 of the interposer 430 may be formed. In this case, the air in the internal space 520 may be discharged to the outside of the printed circuit board assembly 400 by flowing along the third airflow path P3 and the fourth airflow path P4. The air in the internal space 520 may be smoothly discharged to the outside of the printed circuit board assembly 400 by a first airflow path P1 formed by a first through hole 610 and a second through hole 620, a second airflow path P2 formed by the second through hole 620, the third airflow path P3, and/or the fourth airflow path P4. It will be appreciated that the features and/or interplay of the third through hole 1011 and the fourth through hole 1012 may be the same or similar to those/that of the first through hole 610 and the second through hole 620; e.g. the third and fourth airflow paths P3, P4 may function essentially the same as the first and second airflow paths P1, P2, respectively.

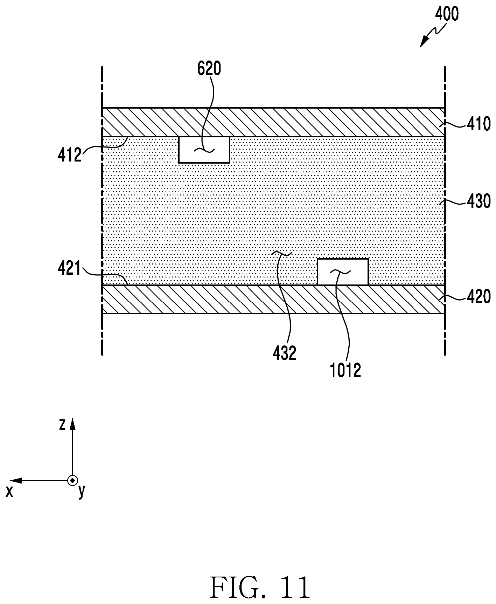

FIGS. 11, 12, 13, and 14 illustrate through holes of a printed circuit board assembly.

Referring to FIG. 11, a first printed circuit board 410 and a second printed circuit board 420 may not include through holes. For example, the first printed circuit board 410 may not include a first through hole (e.g., the first through hole 610 of FIG. 6), and the second printed circuit board 420 may not include a third through hole (e.g., the third through hole 1011 of FIG. 10).

According to an embodiment, in a case of a printed circuit board assembly 400 in which the first printed circuit board 410 and the second printed circuit board 420 do not include through holes, a second through hole 620 and/or a fourth through hole 1012 may extend from an inner side (e.g., the inner side 431 of FIG. 6) of an interposer 430 to an outer side 432 of the interposer 430 to function as a vent hole 403. That is, the first printed circuit board 410 and the second printed circuit board 420 do not include through holes but one or more through hole may be formed or provided in/through the interposer 430 (or a portion from which the interposer 430 has been removed). An internal space (e.g., the internal space 520 of FIG. 6) of the printed circuit board assembly 400 may be connected to the outside of the printed circuit board assembly 400 via the second through hole 620 and/or the fourth through hole 1012 extending from the inner side 431 of the interposer 430 to the outer side 432 of the interposer 430. Air in the internal space 520 may be discharged to the outside of the printed circuit board assembly 400 via a second airflow path (e.g., the second airflow path P2 of FIG. 7) formed by the second through hole 620 and/or a fourth airflow path (e.g., the fourth airflow path P4 of FIG. 10) formed by the fourth through hole 1012.

According to an embodiment, the second through hole 620 may be misaligned with the fourth through hole 1012. For example, when the printed circuit board assembly 400 is viewed from above (e.g., when viewing in a -z direction), the second through hole 620 may not overlap the fourth through hole 1012.

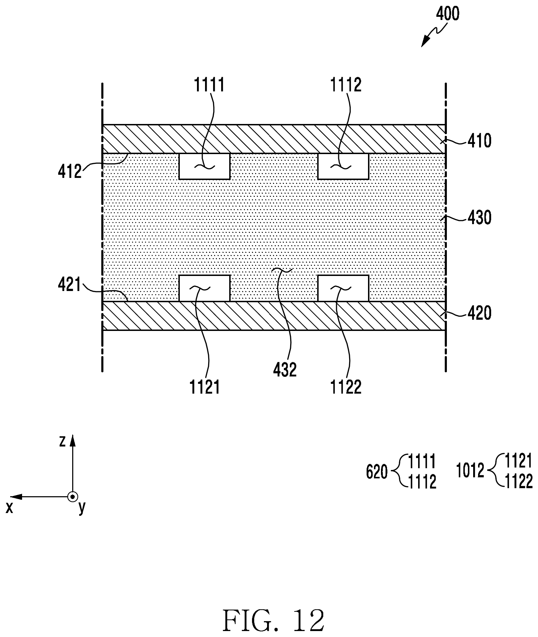

Referring to FIG. 12, the interposer 430 may include a plurality of through holes. For example, the second through hole 620 formed between a rear side 412 of the first printed circuit board 410 and a portion of the interposer 430 may include at least one of a first sub through hole 1111 and/or a second sub through hole 1112. For example, the fourth through hole 1012 formed between a front side 421 of the second printed circuit board 420 and another portion of the interposer 430 may include at least one of a third sub through hole 1121 and/or a fourth sub through hole 1122. The first sub through hole 1111, the second sub through hole 1112, the third sub through hole 1121, and/or the fourth sub through hole 1122 may connect the internal space (e.g., the internal space 520 of FIG. 6) of the printed circuit board assembly 400 to the outside of the printed circuit board assembly 400 by extending from the inner side (e.g., the inner side 431 of FIG. 6) of the interposer 430 to the outer side 432 of the interposer 430.

According to an embodiment, the second through hole 620 may be aligned with the fourth through hole 1012. For example, the first sub through hole 1111 may be aligned with the third sub through hole 1121, and/or the second sub through hole 1112 may be aligned with the fourth sub through hole 1122. For example, when the printed circuit board assembly 400 is viewed from above (e.g., when viewing in the -z direction), the first sub through hole 1111 may overlap the third sub through hole 1121, and the second sub through hole 1112 may overlap the fourth sub through hole 1122.

For example, various combinations of the second through hole 620 and the fourth through hole 1012 may be possible by the first sub through hole 1111, the second sub through hole 1112, the third sub through hole 1121, and/or the fourth sub through hole 1122. For example, at least one of the first sub through hole 1111, the second sub through hole 1112, the third sub through hole 1121, or the fourth sub through hole 1122 may be omitted, and other sub through holes may be further formed. For example, in an example illustrated in FIG. 12, when the second sub through hole 1112 and the third sub through hole 1121 are omitted, the printed circuit board assembly 400 illustrated in FIG. 11 may be provided. Although not illustrated, the printed circuit board assembly 400 including the first sub through hole 1111 and the third sub through hole 1121 or the printed circuit board assembly 400 including the second sub through hole 1112 and the third sub through hole 1121 may be provided.

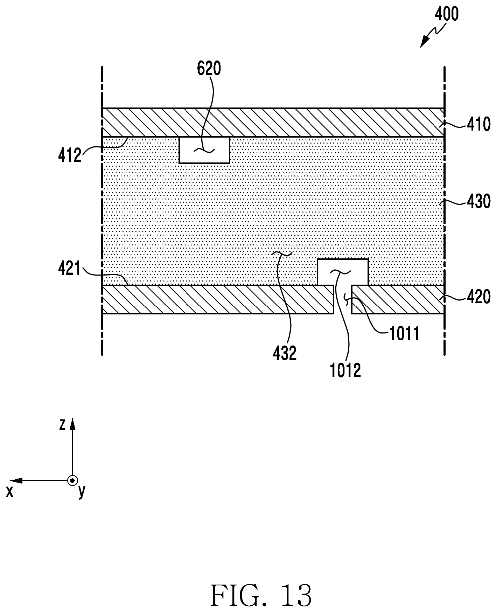

Referring to FIG. 13, the printed circuit board assembly 400 may include the second through hole 620 of the interposer 430, the third through hole 1011 of the second printed circuit board 420, and the fourth through hole 1012 of the interposer 430. The fourth through hole may be connected to the third through hole 1011. In a case of the printed circuit board assembly 400 illustrated in FIG. 13, the air in the internal space 520 of the printed circuit board assembly 400 may be discharged to the outside of the printed circuit board assembly 400 via a second airflow path (e.g., the second airflow path P2 of FIG. 7) formed by the second through hole 620, a third airflow path (e.g., the third airflow path P3 of FIG. 10) formed by the third through hole 1011 and the fourth through hole 1012, and a fourth airflow path (e.g., the fourth airflow path P4 of FIG. 10) formed by the fourth through hole 1012.

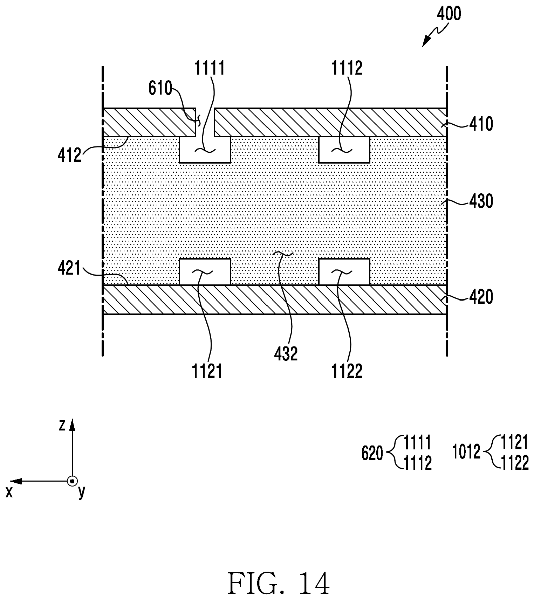

Referring to FIG. 14, the printed circuit board assembly 400 may include the first through hole 610 of the first printed circuit board 410, the second through hole 620 of the interposer 430, and the fourth through hole 1012 of the interposer 430. The first through hole 610 of the first printed circuit board 410 may be connected to any one of the first sub through hole 1111 and the second sub through hole 1112 of the second through hole 620. As illustrated in FIG. 14, the first through hole 610 may be connected to the first sub through hole 1111. In this case, a first airflow path (e.g., the first airflow path P1 of FIG. 7) may be formed by the first through hole 610 and the first sub through hole 1111.

According to an embodiment, the second printed circuit board 420 may not include the third through hole (e.g., the third through hole 1011 of FIG. 13). Even when the second printed circuit board 420 does not include the third through hole 1011, the interposer 430 may include the fourth through hole 1012. For example, the fourth through hole 1012 may be formed between the front side 421 of the second printed circuit board 420 and another portion of the interposer 430. For example, the fourth through hole 1012 may include the third sub through hole 1121 and/or the fourth sub through hole 1122. The fourth airflow path (e.g., the fourth airflow path P4 of FIG. 10) may be formed by the third sub through hole 1121 and/or the fourth sub through hole 1122.

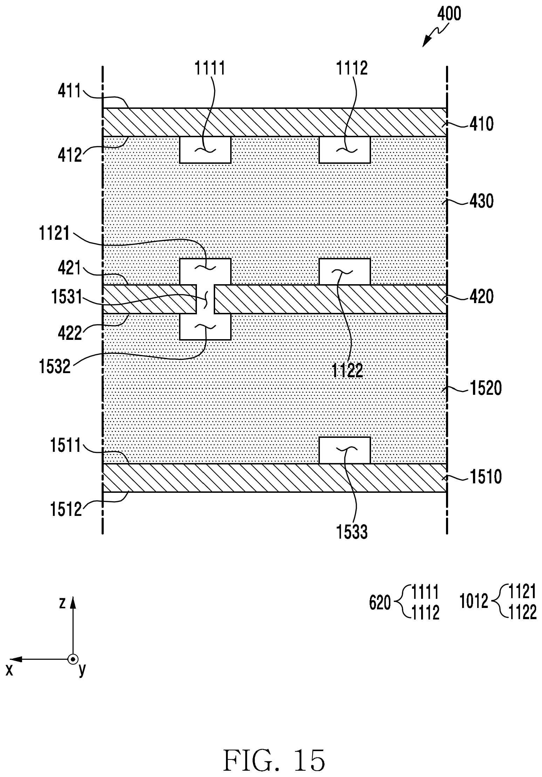

FIG. 15 illustrates a printed circuit board assembly including three printed circuit boards.

In the examples described above, a printed circuit board assembly 400 including two printed circuit boards (e.g., a first printed circuit board 410 and a second printed circuit board 420) is described, but embodiments of the present disclosure are not limited thereto. For example, the printed circuit board assembly 400 may include three or more printed circuit boards.

Referring to FIG. 15, the printed circuit board assembly 400 may include three printed circuit boards. For example, the printed circuit board assembly 400 may include the first printed circuit board 410, the second printed circuit board 420, a third printed circuit board 1510, an interposer 430 (or first interposer 430), and another interposer 1520 (or second interposer 1520). The third printed circuit board 1510 may be disposed below (e.g., a -z direction) the second printed circuit board 420. The other interposer 1520 may be disposed between a peripheral portion (e.g., a second peripheral portion) of the second printed circuit board 420 and a peripheral portion (e.g., a third peripheral portion) of the third printed circuit board 1510. The other interposer 1520 may be configured to electrically connect the second printed circuit board 420 and the third printed circuit board 1510.

According to an embodiment, the other interposer 1520 may include a fifth through hole 1532 connected to a fourth through hole 1012 of the interposer 430 via a third through hole 1531 of the second printed circuit board 420. For example, a third sub through hole 1121 of the fourth through hole 1012, the third through hole 1531 of the second printed circuit board 420, and the fifth through hole 1532 of the other interposer 1520 may be connected to each other. As the third through hole 1531, the fourth through hole 1012, and the fifth through hole 1532 are connected to each other, a through hole having a relatively wide cross-sectional area may be formed. The third through hole 1531, the fourth through hole 1012, and the fifth through hole 1532 may provide a path through which air in an internal space of the printed circuit board assembly 400 is discharged to the outside of the printed circuit board assembly 400.

According to an embodiment, the other interposer 1520 may include a sixth through hole 1533 formed between a front side 1511 of the third printed circuit board 1510 and a portion of the other interposer 1520. The sixth through hole 1533 may connect a rear side 422 of the second printed circuit board 420, an inner side of the other interposer 1520, and the internal space of the printed circuit board assembly 400 defined by the front side 1511 of the third printed circuit board 1510 to the outside of the printed circuit board assembly 400. The air in the internal space may be discharged to the outside of the printed circuit board assembly 400 via the sixth through hole 1533.

As described above, a second through hole 620 of the interposer 430 may form at least a portion of a vent hole (e.g., the vent hole 403 of FIG. 4). For example, a first through hole 610 and the second through hole 620 may function as the vent hole 403 of the printed circuit board assembly 400. For example, the second through hole 620 may function alone as the vent hole 403 of the printed circuit board assembly 400. In addition to the vent hole 403, the second through hole 620 of the interposer 430 may function as an inspection hole (e.g., the inspection hole 402 of FIG. 4) or an injection hole (e.g., the injection hole 401 of FIG. 4).

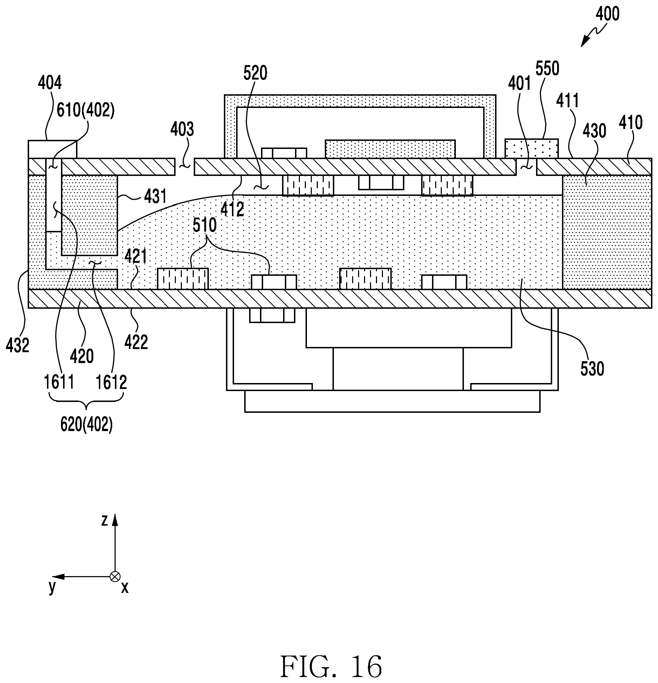

Hereinafter, examples in which the second through hole 620 functions as the inspection hole (e.g., an inspection hole 402 of FIG. 16) will be described. With respect to components that are identical to the components described above, the same reference numeral may be assigned, and overlapping descriptions may be omitted.

FIG. 16 illustrates a printed circuit board assembly including a first through hole and a second through hole functioning as an inspection hole.

Referring to FIG. 16, a first through hole 610 of a first printed circuit board 410 and a second through hole 620 of an interposer 430 may be configured to function as an inspection hole 402.

According to an embodiment, the second through hole 620 of the interposer 430 may include a first portion 1611 and a second portion 1612. For example, the first portion 1611 of the second through hole 620 may be aligned with the first through hole 610 of the first printed circuit board 410. For example, the first portion 1611 may extend from the first printed circuit board 410 (e.g. from the first through hole 610 or a region where the second through hole 620 is connected to or joins the first through hole 610) in a first direction toward the second printed circuit board 420. The first direction may be referred to as a -z direction of FIG. 16. For example, the second portion 1612 of the second through hole 620 may extend from an end portion of the first portion 1611 to an inner side 431 of the interposer 430 (or towards the internal space 520). For example, the second portion 1612 may extend in a second direction perpendicular to the first direction. The second direction may be referred to as a -y direction of FIG. 16. The second portion 1612 may be connected to an internal space 520 of a printed circuit board assembly 400.

According to an embodiment, a thermal interface material 530 may be injected into the internal space 520 of the printed circuit board assembly 400. The thermal interface material 530 may occupy at least a portion of the internal space 520. One or more electronic components 510 disposed in the internal space 520 may contact the thermal interface material 530. When the thermal interface material 530 is injected, the inspection hole 402 that allows the internal space 520 to be visible may be required to inspect a state in which the thermal interface material 530 is injected into the internal space 520.

According to an embodiment, the first through hole 610 and the second through hole 620 may be configured to function as the inspection hole 402. When the thermal interface material 530 is injected into the internal space 520 of the printed circuit board assembly 400, the thermal interface material 530 may fill the internal space 520. As a space occupied by the thermal interface material 530 increases when the thermal interface material 530 is continuously injected, the thermal interface material 530 may rise from a front side 421 of the second printed circuit board 420 (or from a region of the front side 410 of the second printed circuit board 420 under the nozzle 540) toward a rear side 412 of the first printed circuit board 410. As the thermal interface material 530 is injected, the thermal interface material 530 may be introduced or flow into the second portion 1612 of the second through hole 620 connected to the internal space 520. When the second portion 1612 of the second through hole 620 is filled with the thermal interface material 530, the thermal interface material 530 may be introduced or flow into the first portion 1611 of the second through hole 620 aligned with the first through hole 610 of the first printed circuit board 410. Since the first portion 1611 may be visible via the first through hole 610 aligned with the first portion 1611, an injection state of the thermal interface material 530 may be inspected via the thermal interface material 530 filling at least a portion of the first portion 1611. The printed circuit board assembly 400 may include an injection hole 401 and a vent hole 403 in addition to the inspection hole 402. For example, the first printed circuit board 410 may include the injection hole 401 and the vent hole 403. In various embodiments, the vent hole 403 may be provided in a manner according to any of the embodiments described above, with one or more through holes formed in the interposer 430 and one or more through holes formed in the first printed circuit board 410 and/or the second printed circuit board 420 so as not to conflict with the first and second through holes of FIG. 16.

The printed circuit board assembly 400 according to an embodiment may include a cap 404. The cap 404 may be disposed on a front side 411 of the first printed circuit board 410 to cover the first through hole 610 configured to function as the inspection hole 402. The cap 404 covering the inspection hole 402 may be configured to prevent and/or reduce a foreign substance from being introduced into the internal space 520 of the printed circuit board assembly 400 via the inspection hole 402. The cap 404 may be substantially transparent so that the inspection hole 402 may be visible from the outside of the printed circuit board assembly 400.

If a position of the inspection hole formed on the first printed circuit board is formed at a position spaced apart from the interposer, an area for disposing an electronic component may be reduced, since an electronic component may not be disposed around the inspection hole.

Since the printed circuit board assembly 400 according to an embodiment may use the first through hole 610 positioned in a first peripheral portion of the first printed circuit board 410 in contact with the interposer 430 as the inspection hole 402, the area for disposing the electronic component may not be reduced. Since the first peripheral portion is a portion in which the electronic component may not be disposed, even when the first through hole 610 is formed in the first peripheral portion, the area for disposing the electronic component may not change. Even when the printed circuit board assembly 400 includes the first through hole 610, the area for disposing the electronic component may be maintained. That is, by forming the first through hole 610 in a region between the first peripheral portion or the second peripheral portion and using it as, e.g., the inspection hole 402, the area of the printed circuit board assembly 400 for disposing an electronic component is greater than in a case where the inspection hole 402 is formed in relation to a region of the first or second printed circuit boards 410, 420 other than region between the first and second peripheral portions. As a result, there is more space or area within the printed circuit board assembly 400 for disposing electronic components 510. Since the first peripheral portion is in contact with the interposer 430, the second through hole 620 may be formed in the interposer 430 so that the thermal interface material 530 may be visible. The injection state of the thermal interface material 530 may be visible via the first portion 1611 of the second through hole 620 and the second portion 1612 of the second through hole 620.

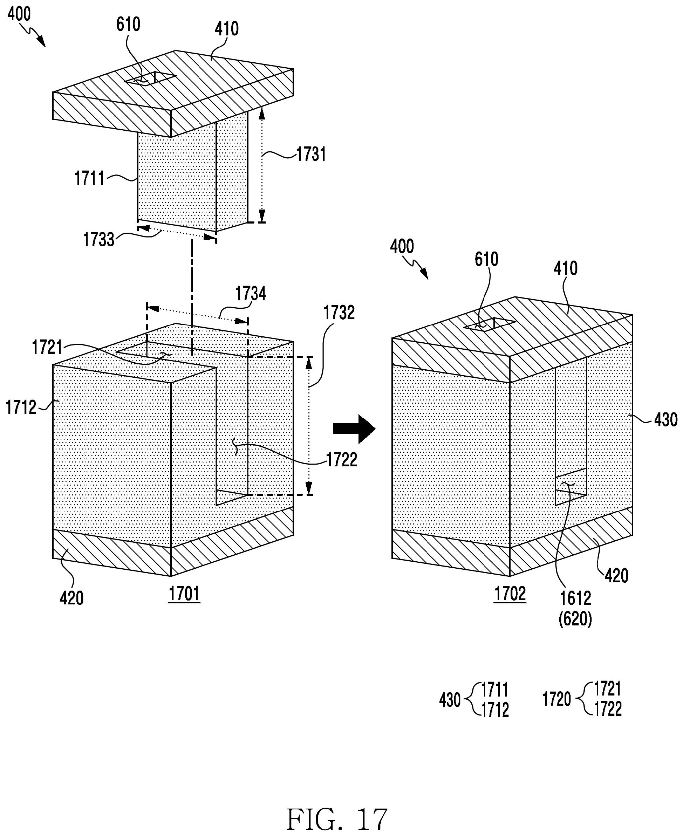

FIG. 17 illustrates an assembly process of the printed circuit board assembly of FIG. 16.

A first state 1701 of FIG. 17 indicates a state before or during assembly of the printed circuit board assembly 400 including the second through hole 620 of FIG. 16. A second state 1702 of FIG. 17 indicates a state after assembly of the printed circuit board assembly 400 including the second through hole 620.

According to an embodiment, an interposer 430 may include a first part 1711 and a second part 1712. The first part 1711 may be connected to a first printed circuit board 410. The second part 1712 may be connected to a second printed circuit board 420.

According to an embodiment, the first part 1711 and the second part 1712 may have a structure for forming a second through hole (e.g., the through hole 620 of FIG. 16) including a first portion (e.g., the first portion 1611 of FIG. 16) and a second portion (e.g., the second portion 1612 of FIG. 16). For example, the second part 1712 may include a recess 1720 into which the first part 1711 is inserted. The first part 1711 and the recess 1720 of the second part 1712 may have an approximately rectangular parallelepiped shape. The first part 1711 connected to the first printed circuit board 410 may be inserted into the recess 1720 of the second part 1712. When the first part 1711 is inserted into the recess 1720, the first portion 1611 of the second through hole 620 and the second portion 1612 of the second through hole 620 may be formed by a gap between the first part 1711 and the recess 1720 (e.g. between the first part 1711 and the surfaces of the recess 1720) or, to put another way, by a gap between the first part 1711 and the second part 1712 corresponding to a portion of the recess 1720 in which the first part 1711 is not disposed.

According to an embodiment, a first height 1731 of the first part 1711 may be lower than a second height 1732 of a height portion 1722 of the recess 1720. Since the first height 1731 is lower than the second height 1732, the first part 1711 may be spaced apart from a bottom side of the recess 1720, when the first part 1711 is inserted into the recess 1720 of the second part 1712. The second portion 1612 of the second through hole 620 may be formed by a gap between the first part 1711 and the bottom side of the recess 1720.

According to an embodiment, a first width 1733 of the first part 1711 may be narrower than a second width 1734 of a width portion 1721 of the recess 1720. Since the first width 1733 is narrower than the second width 1734, the first part 1711 may be spaced apart from a sidewall of the recess 1720, when the first part 1711 is inserted into the recess 1720 of the second part 1712. The first portion 1611 of the second through hole 620 may be formed by a gap between the first part 1711 and the sidewall of the recess 1720. By the structure, the second through hole 620 including the first portion 1611 and the second portion 1612 may be formed. The first part 1711 may be formed so as not to block or cover the first through hole 610, thereby allowing for the first through hole 610 to be open to the recess 1720.

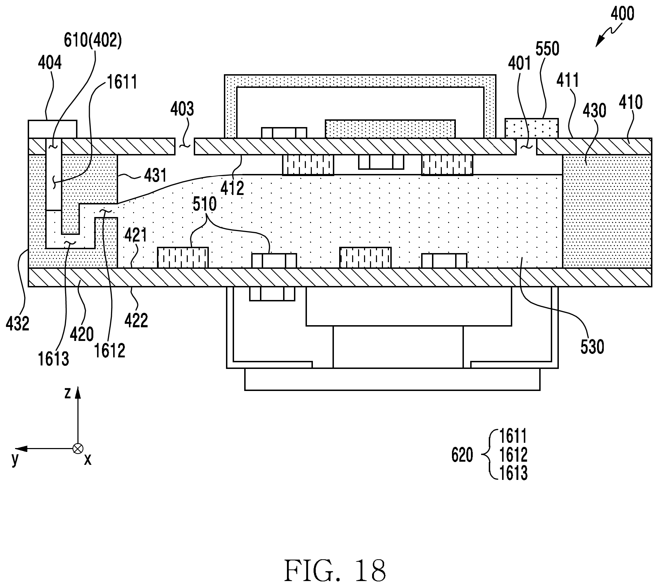

FIG. 18 illustrates a printed circuit board assembly including a first through hole and a second through hole functioning as an inspection hole.

Referring to FIG. 18, a second through hole 620 may further include a third portion 1613 disposed between a first portion 1611 and a second portion 1612. For example, the first portion 1611 may be aligned with a first through hole 610 and extend in a first direction. For example, the second portion 1612 may be connected to an internal space 520 of a printed circuit board assembly 400 and extend in a second direction or at least partly in a second direction, which may be perpendicular to the first direction. For example, the third portion 1613 may be bent (e.g. in a U-shape) between the first portion 1611 and the second portion 1612 to increase an overall length of the second through hole 620. For example, the overall length of the second through hole 620 of FIG. 18 including the bent third portion 1613 may be longer than an overall length of the second through hole 620 of FIG. 16 including the second portion 1612 connected to the first portion 1611 by linearly extending. In various embodiments, the third portion 1613 may be regarded as an extension of the first portion 1611 or the second portion 1612 (i.e. does not need to be separately recited).

For example, a height of the internal space 520 of the printed circuit board assembly 400 may correspond to a distance between a front side 421 of a second printed circuit board 420 and a rear side 412 of a first printed circuit board 410. Since a position of the second portion 1612 of the second through hole 620 is spaced from the front side 421 of the second printed circuit board 420 toward the first printed circuit board 410 (e.g., toward a +z direction), a height of a thermal interface material 530 filling the internal space 520 may be different from a height of the thermal interface material 530 filling the first portion 1611. The third portion 1613 may be formed so that the height of the thermal interface material 530 filling the internal space 520 corresponds to the height of the thermal interface material 530 filling the first portion 1611. For example, by providing the third portion 1613 the height of the thermal interface material 530 filling the internal space 520 may be substantially the same as the height of the thermal interface material 530 filling the first portion 1611. Since the height of the thermal interface material 530 filling the internal space 520 may be substantially the same as the height of the thermal interface material 530 filling the first portion 1611 by the third portion 1613, an injection state of the thermal interface material 530 that is visible via an inspection hole 402 may be accurately inspected.

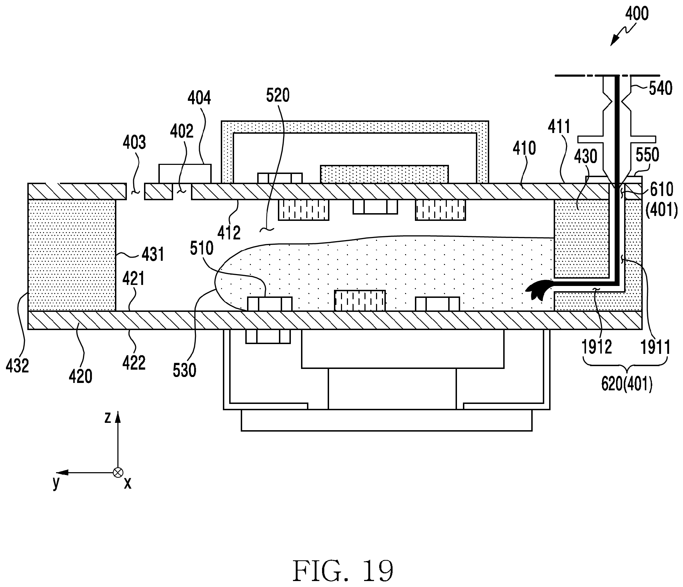

Hereinafter, examples in which the second through hole 620 functions as an injection hole (e.g., an injection hole 401 of FIG. 19) will be described. With respect to components that are identical to the components described above, the same reference numeral may be assigned, and overlapping descriptions may be omitted.

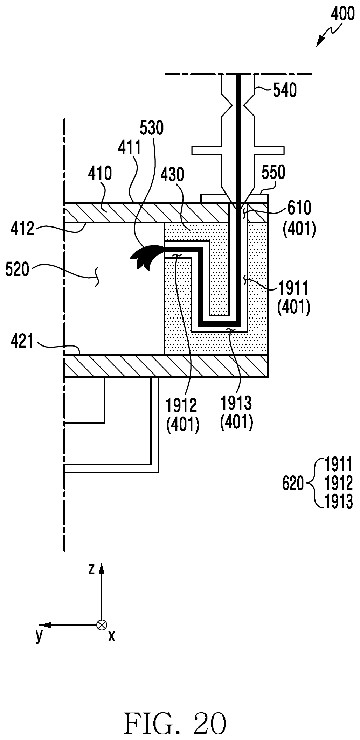

FIGS. 19 and 20 illustrate a printed circuit board assembly including a first through hole and a second through hole functioning as an injection hole.

Referring to FIG. 19, a first through hole 610 of a first printed circuit board 410 and a second through hole 620 of an interposer 430 may be configured to function as an injection hole 401 for injecting a thermal interface material 530 into an internal space 520 of a printed circuit board assembly 400.

According to an embodiment, the second through hole 620 may include a first portion 1911 and a second portion 1912. The first portion 1911 and the second portion 1912 of the second through hole 620 configured to function as the injection hole 401 may be substantially the same as the first portion 1611 and the second portion 1612 of FIG. 16. For example, the first portion 1911 may extend from the first printed circuit board 410 in a first direction (e.g., a -z direction) toward the second printed circuit board 420. For example, the second portion 1912 of the second through hole 620 may extend from an end portion of the first portion 1911 to an inner side 431 of the interposer 430. For example, the second portion 1912 may extend in a second direction (e.g., a -y direction) perpendicular to the first direction. The second portion 1912 may be connected to the internal space 520 of the printed circuit board assembly 400.

According to an embodiment, a nozzle 540 may inject the thermal interface material 530 via the first through hole 610 and the second through hole 620 configured to function as the injection hole 401. The printed circuit board assembly 400 may include a damper pad 550. The damper pad 550 may be disposed on a front side 411 of the first printed circuit board 410 to cover the first through hole 610. An end portion of the nozzle 540 through which the thermal interface material 530 is discharged may be inserted into a cut groove of the first through hole 610 and positioned in the first through hole 610.

For example, the thermal interface material 530 may be discharged from the nozzle 540. The thermal interface material 530 discharged from the end portion of the nozzle 540 may be introduced or flow into the first through hole 610. The thermal interface material 530 introduced into the first through hole 610 may flow to the first portion 1911 of the second through hole 620 aligned with the first through hole 610. The thermal interface material 530 may flow to the end portion of the first portion 1911 of the second through hole 620 and then flow to the second portion 1912 of the second through hole 620 connected to the end portion of the first portion 1911. The thermal interface material 530 flowing to the second portion 1912 of the second through hole 620 may flow to the internal space 520 of the printed circuit board assembly 400 connected to the second portion 1912. The thermal interface material 530 flowing to the internal space 520 of the printed circuit board assembly 400 may fill at least a portion of the internal space 520. The printed circuit board assembly 400 according to an embodiment may include an inspection hole 402 and a vent hole 403. For example, the first printed circuit board 410 may include the injection hole 401 and the vent hole 403. In various embodiments, the vent hole 403 may be provided in a manner according to any of the embodiments described above, with one or more through holes formed in the interposer 430 and one or more through holes formed in the first printed circuit board 410 and/or the second printed circuit board 420 so as not to conflict with the first and second through holes of FIG. 19. Additionally or alternatively, the inspection hole 402 may be provided in a manner according to any of the embodiments described above, with one or more through holes formed in the interposer 430 and one or more through holes formed in the first printed circuit board 410 and/or the second printed circuit board 420 so as not to conflict with the first and second through holes of FIG. 19.

In case that a position of the injection hole formed on the first printed circuit board is formed at a position spaced apart from the interposer, an area for disposing an electronic component may be reduced since the electronic component may not be disposed around the injection hole.

Since the printed circuit board assembly 400 according to an embodiment may use the first through hole 610 positioned in a first peripheral portion of the first printed circuit board 410 in contact with the interposer 430 as the injection hole 401, the area for disposing the electronic component may not be reduced. Since the first peripheral portion is a portion in which the electronic component may not be disposed, even when the first through hole 610 is formed in the first peripheral portion, the area for disposing the electronic component may not change. Even when the printed circuit board assembly 400 includes the first through hole 610, the area for disposing the electronic component may be maintained. That is, by forming the first through hole 610 in a region between the first peripheral portion or the second peripheral portion and using it as, e.g., the injection hole 401, the area of the printed circuit board assembly 400 for disposing an electronic component is greater than in a case where the injection hole 401 is formed in relation to a region of the first or second printed circuit boards 410, 420 other than region between the first and second peripheral portions (e.g. as shown in FIG. 5). As a result, there is more space or area within the printed circuit board assembly 400 for disposing electronic components 510. Since the first peripheral portion is in contact with the interposer 430, the second through hole 620 may be formed in the interposer 430 so that the thermal interface material 530 discharged from the nozzle 540 may be transferred to the inside of the printed circuit board assembly 400. The thermal interface material 530 may be injected into the internal space 520 via the first portion 1911 of the second through hole 620 and the second portion 1912 of the second through hole 620.

Referring to FIG. 20, the second through hole 620 may further include a third portion disposed between the first portion 1911 and the second portion 1912. For example, the first portion 1911 may be aligned with the first through hole 610 and extend in the first direction. For example, the second portion 1912 may be connected to the internal space 520 of the printed circuit board assembly 400 and extend in the second direction or at least partly in a second direction, which may be perpendicular to the first direction. For example, the third portion may be bent (e.g. in a U-shape) between the first portion 1911 and the second portion 1912 to increase an overall length of the second through hole 620. For example, the overall length of the second through hole 620 of FIG. 20 including the bent third portion may be longer than an overall length of the second through hole 620 of FIG. 19 including the second portion 1912 connected to the first portion 1911 by linearly extending. The third portion 1913 may be similar to the third portion 1613 of FIG. 18.

For example, the second portion 1912 may be spaced apart from a front side 421 of the second printed circuit board 420 toward the first printed circuit board 410. The thermal interface material 530 discharged from the nozzle 540 may pass through the second portion 1912 and be introduced into the internal space 520 of the printed circuit board assembly 400. In a case that a position of the second portion 1912 is too close to the front side 421 of the second printed circuit board 420, the thermal interface material 530 injected into the internal space 520 of the printed circuit board assembly 400 may obstruct the second portion 1912. When the second portion 1912 is obstructed by the thermal interface material 530, it may be difficult for the thermal interface material 530 to pass through the second portion 1912 and be injected into the internal space 520. In order to push out (e.g. overcome the obstruction) the thermal interface material 530, pressure of the nozzle 540 may be increased. In order to easily inject the thermal interface material 530 into the internal space 520, the position of the second portion 1912 may be closer to a rear side 412 of the first printed circuit board 410 than the front side 421 of the second printed circuit board 420 (e.g. moved upwards, in the +z direction). In a case that the second portion 1912 is adjacent or proximate to the rear side 412 of the first printed circuit board 410, the first through hole 610 of the first printed circuit board 410 and the second portion 1912 of the second through hole 620 may be positioned close to each other. In a case that the first through hole 610 and the second portion 1912 of the second through hole 620 are positioned close to each other, an overall length of the injection hole 401 may be shortened. As the overall length of the injection hole 401 is shortened, it may be difficult to adjust an amount of the thermal interface material 530 injected into the internal space 520.

According to an embodiment, the third portion may increase the overall length of the second through hole 620 by being bent between the first portion 1911 and the second portion 1912. As the overall length of the second through hole 620 increases, the overall length of the injection hole 401 may increase. Since the third portion increases the overall length of the injection hole 401, the amount of the thermal interface material 530 injected into the internal space 520 of the printed circuit board assembly 400 may be easily adjusted (i.e. is more controllable), even when the second portion 1912 of the second through hole 620 is adjacent or proximate to the rear side 412 of the first printed circuit board 410.

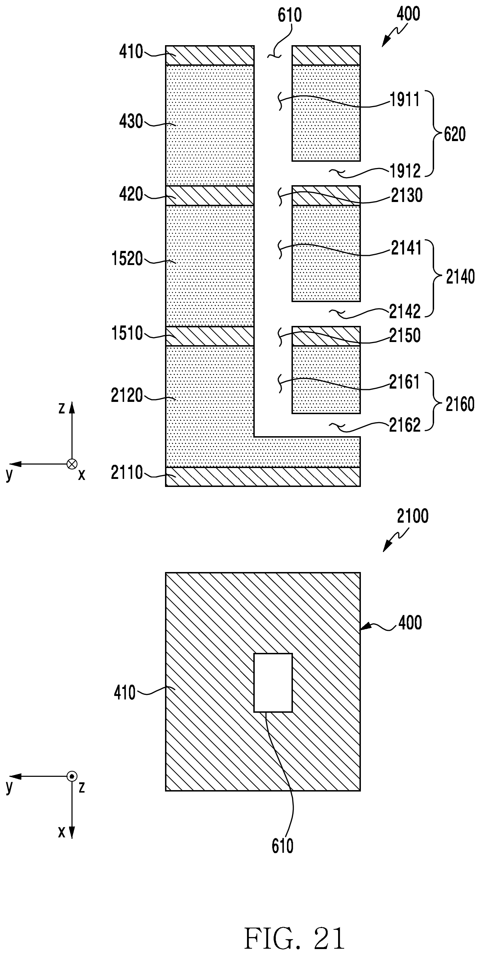

FIGS. 21, 22, 23, and 24 illustrate a process of inspecting an injection amount of a thermal interface material using an inspection hole.

Referring to FIG. 21, a printed circuit board assembly 400 according to an embodiment may include a first printed circuit board 410, a second printed circuit board 420, a third printed circuit board 1510, and a fourth printed circuit board 2110. The fourth printed circuit board 2110 may be disposed below (e.g., a -z direction) the third printed circuit board 1510. The interposer (e.g., the interposer 430 of FIG. 6) described above may correspond to a first interposer 430. The other interposer (e.g., the other interposer 1520 of FIG. 15) described above may correspond to a second interposer 1520. The printed circuit board assembly 400 may include a third interposer 2120 disposed between the third printed circuit board 1510 and the fourth printed circuit board 2110. The third printed circuit board 1510 and the fourth printed circuit board 2110 may be electrically connected via the third interposer 2120.

According to an embodiment, the printed circuit board assembly 400 may include a first through hole 610, a second through hole 620, a third through hole 2130, a fourth through hole 2140, a fifth through hole 2150, and a sixth through hole 2160 configured to function as an inspection hole (e.g., the inspection hole 402 of FIG. 4).

For example, the first printed circuit board 410 may include the first through hole 610. The first through hole 610 may correspond to the first through hole (e.g., the first through hole 610 of FIG. 6) described above. For example, the first interposer 430 may include the second through hole 620. The second through hole 620 of the interposer 430 may correspond to the second through hole 620 of FIG. 16 or FIG. 19. For example, the second through hole 620 may include a first portion 1911 and a second portion 1912. The first portion 1911 of the second through hole 620 may extend in a first direction (e.g., the -z direction) and may be aligned with the first through hole 610 of the first printed circuit board 410. The second portion 1912 of the second through hole 620 may be connected to an internal space (e.g., the internal space 520 of FIG. 6) of the printed circuit board assembly 400 defined by the first printed circuit board 410, the second printed circuit board 420, and the first interposer 430. The second portion 1912 of the second through hole 620 may extend from an end portion of the first portion 1911 in a second direction (e.g., a -y direction) perpendicular to the first direction.

For example, the second printed circuit board 420 may include the third through hole 2130. The third through hole 2130 may be connected to the first portion 1911 of the second through hole 620 by being aligned with the first portion 1911 of the second through hole 620. The third through hole 2130 may be connected to the second through hole 620 and, indirectly (i.e. via the second through hole 620), the first through hole 610.

For example, the second interposer 1520 may include the fourth through hole 2140. The fourth through hole 2140 may include a third portion 2141 and a fourth portion 2142. The third portion 2141 of the fourth through hole 2140 may be connected to the third through hole 2130 by being aligned with the third through hole 2130 of the second printed circuit board 420. The third portion 2141 of the fourth through hole 2140 may extend in the first direction. The fourth portion 2142 of the fourth through hole 2140 may be connected to an internal space of the printed circuit board assembly 400 defined by the second printed circuit board 420, the third printed circuit board 1510, and the second interposer 1520. The fourth portion 2142 of the fourth through hole 2140 may extend from an end portion of the third portion 2141 in the second direction perpendicular to the first direction.

For example, the third printed circuit board 1510 may include the fifth through hole 2150. The fifth through hole 2150 may be connected to the third portion 2141 of the fourth through hole 2140 by being aligned with the third portion 2141 of the fourth through hole 2140. The fifth through hole 2150 may be connected to the fourth through hole 2140 and, indirectly (i.e. via the fourth through hole 2140), the third through hole 2130.

For example, the third interposer 2120 may include the sixth through hole 2160. The sixth through hole 2160 may include a fifth portion 2161 and a sixth portion 2162. The fifth portion 2161 of the sixth through hole 2160 may be connected to the fifth through hole 2150 by being aligned with the fifth through hole 2150 of the third printed circuit board 1510. The fifth portion 2161 of the sixth through hole 2160 may extend in the first direction. The sixth portion 2162 of the sixth through hole 2160 may be connected to an internal space of the printed circuit board assembly 400 defined by the third printed circuit board 1510, the fourth printed circuit board 2110, and the third interposer 2120. The sixth portion 2162 of the sixth through hole 2160 may extend from an end portion of the fifth portion 2161 in the second direction perpendicular to the first direction.

According to an embodiment, referring to a plan view 2100 in which the printed circuit board assembly 400 of FIG. 21 is viewed from above (e.g., the -z direction), the first printed circuit board 410 and the first through hole 610 may be visible. Since the first through hole 610 is aligned with the first portion 1911 of the second through hole 620, the third through hole 2130, the third portion 2141 of the fourth through hole 2140, the fifth through hole 2150 and the fifth portion 2161 of the sixth through hole 2160, as a result the first portion 1911 of the second through hole 620, the third through hole 2130, the third portion 2141 of the fourth through hole 2140, the fifth through hole 2150, and the fifth portion 2161 of the sixth through hole 2160 may be all visible via the first through hole 610.

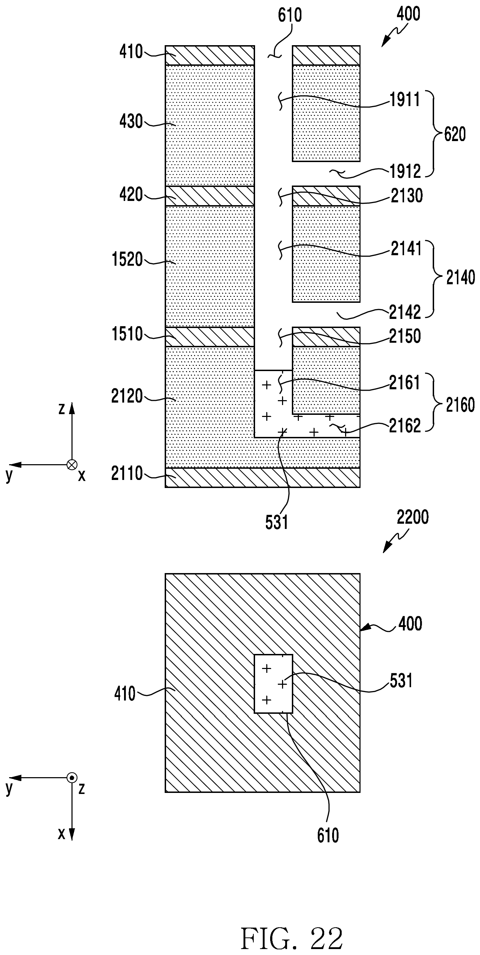

FIG. 22 illustrates a state in which a first thermal interface material is injected into the internal space of the printed circuit board assembly 400 defined by the third printed circuit board 1510, the fourth printed circuit board 2110, and the third interposer 2120. The first thermal interface material, which is a thermal interface material injected into the internal space, may have a first color. When the first thermal interface material is injected into the internal space, the first thermal interface material may be introduced into the sixth portion 2162 of the sixth through hole 2160 connected to the internal space. When the first thermal interface material is continuously injected, the first thermal interface material may fill or flow into the fifth portion 2161 of the sixth through hole 2160 via the sixth portion 2162.

According to an embodiment, referring to a plan view 2200 in which the printed circuit board assembly 400 of FIG. 22 is viewed from above (e.g., the -z direction), the first thermal interface material having the first color may be visible when the first through hole 610 is viewed from above. As the first thermal interface material having the first color may be visible, an injection state of the first thermal interface material injected into the internal space may be inspected.

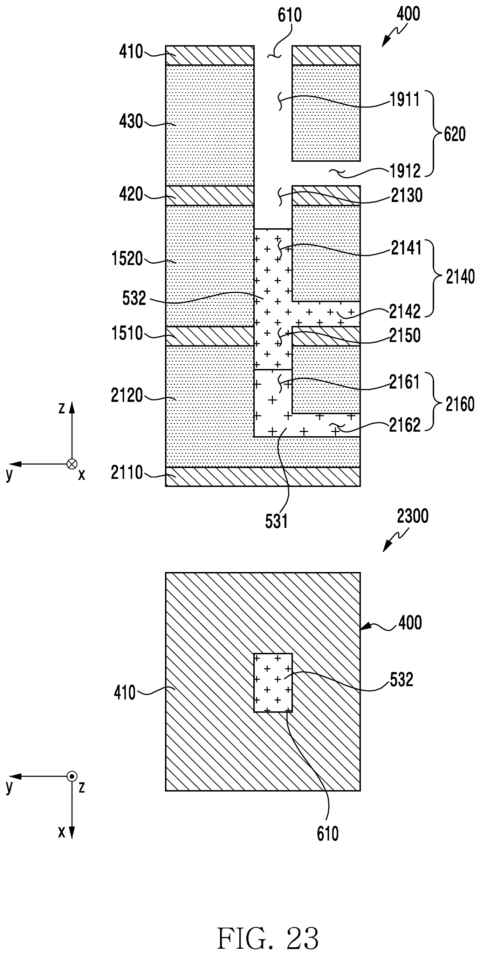

FIG. 23 illustrates a state in which a second thermal interface material is injected into the internal space of the printed circuit board assembly 400 defined by the second printed circuit board 420, the third printed circuit board 1510, and the second interposer 1520. The second thermal interface material, which is a thermal interface material injected into the internal space, may have a second color different from the first color. When the second thermal interface material is injected into the internal space, the second thermal interface material may be introduced into the fourth portion 2142 of the fourth through hole 2140 connected to the internal space. When the second thermal interface material is continuously injected, the second thermal interface material may fill the third portion 2141 of the fourth through hole 2140 via the fourth portion 2142.

According to an embodiment, referring to a plan view 2300 in which the printed circuit board assembly 400 of FIG. 23 is viewed from above (e.g., the -z direction), the second thermal interface material having the second color may be visible when the first through hole 610 is viewed from above. As the second thermal interface material having the second color may be visible, an injection state of the second thermal interface material injected into the internal space may be inspected.

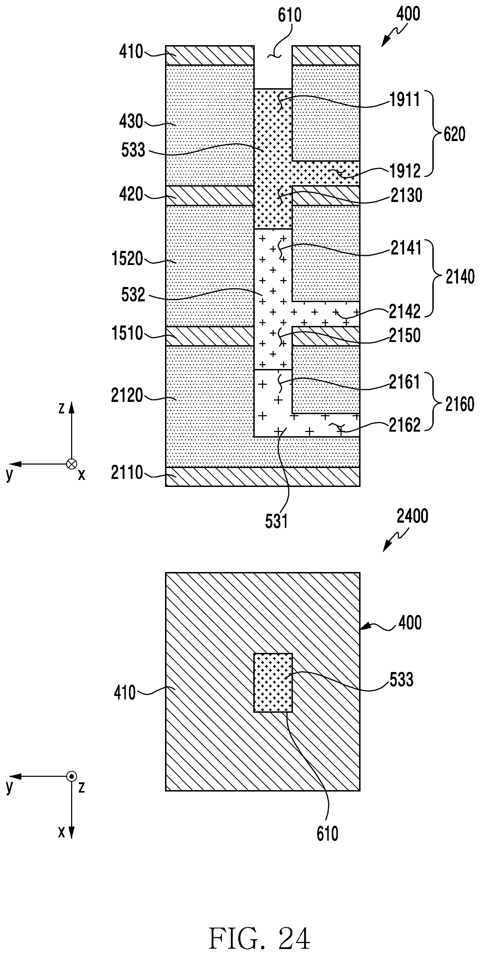

FIG. 24 illustrates a state in which a third thermal interface material is injected into the internal space (e.g., the internal space 520 of FIG. 6) of the printed circuit board assembly 400 defined by the first printed circuit board 410, the second printed circuit board 420, and the first interposer 430. The third thermal interface material, which is a thermal interface material injected into the internal space 520, may have a third color different from the first color and the second color. When the third thermal interface material is injected into the internal space 520, the third thermal interface material may be introduced into the second portion 1912 of the second through hole 620 connected to the internal space 520. When the third thermal interface material is continuously injected, the third thermal interface material may fill the first portion 1911 of the second through hole 620 via the second portion 1912.

According to an embodiment, referring to a plan view 2400 in which the printed circuit board assembly 400 of FIG. 24 is viewed from above (e.g., the -z direction), the third thermal interface material having the third color may be visible when the first through hole 610 is viewed from above. As the third thermal interface material having the third color may be visible, an injection state of the third thermal interface material injected into the internal space 520 may be inspected. According to an embodiment, the first through hole 610, the second through hole 620, the third through hole 2130, the fourth through hole 2140, the fifth through hole 2150, and the sixth through hole 2160 aligned with each other may be configured to function as the inspection hole (e.g., the inspection hole 402 of FIG. 4) so that the injection state of the thermal interface material may be identified.

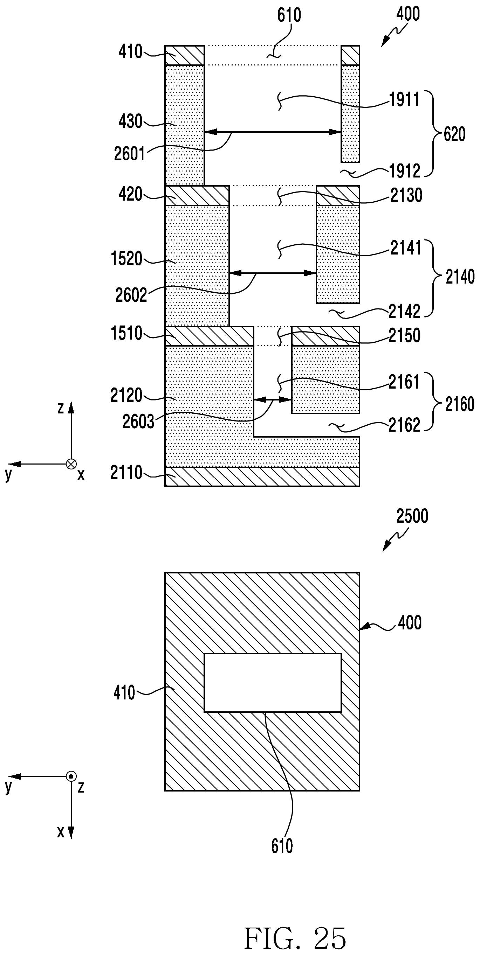

FIGS. 25, 26, 27, and 28 illustrate a process of inspecting an injection amount of a thermal interface material using an inspection hole.

Components of a printed circuit board assembly 400 illustrated in FIG. 25 may correspond to each of components of the printed circuit board assembly 400 illustrated in FIG. 21. As described below, each of remaining components, excluding a structure according to a width, may correspond to each of the components illustrated in FIG. 21. With respect to the same components, the same reference numeral may be assigned, and overlapping descriptions may be omitted.

Referring to FIG. 25, a first portion 1911 of a second through hole 620, a third portion 2141 of a fourth through hole 2140, and a fifth portion 2161 of a sixth through hole 2160 may have different widths. Herein, a width may be referred to as a length in a y-axis direction. For example, a second width 2602 of the third portion 2141 may be narrower than a first width 2601 of the first portion 1911 and may be wider than a third width 2603 of the fifth portion 2161. For example, the first width 2601 may be wider than the second width 2602 and the third width 2603, and the third width 2603 may be narrower than the first width 2601 and the second width 2602. The first width 2601 of the first portion 1911 may correspond to a width of a first through hole 610 of a first printed circuit board 410. The second width 2602 of the third portion 2141 may correspond to a width of a third through hole 2130 of a second printed circuit board 420. The third width 2603 of the fifth portion 2161 may correspond to a width of a fifth through hole 2150 of a third printed circuit board 1510. As the first width 2601, the second width 2602, and the third width 2603 are formed differently from each other, an injection state of a thermal interface material (e.g., the thermal interface material 530 of FIG. 6) may be inspected.

According to an embodiment, referring to a plan view 2500 in which the printed circuit board assembly 400 of FIG. 25 is viewed from above (e.g., a -z direction), the first printed circuit board 410 and the first through hole 610 may be visible. The first through hole 610 and the first portion 1911 of the second through hole 620 aligned with the first through hole 610 may have a first width 2601 that is wider than the second width 2602 of the third through hole 2130 and the third portion 2141 of the fourth through hole 2140 and the third width 2603 of the fifth through hole 2150 and the fifth portion 2161 of the sixth through hole 2160. In a state before filling a thermal interface material 530, the second through hole 620, the third through hole 2130, the fourth through hole 2140, the fifth through hole 2150, and the sixth through hole 2160 may all be visible via the first through hole 610.

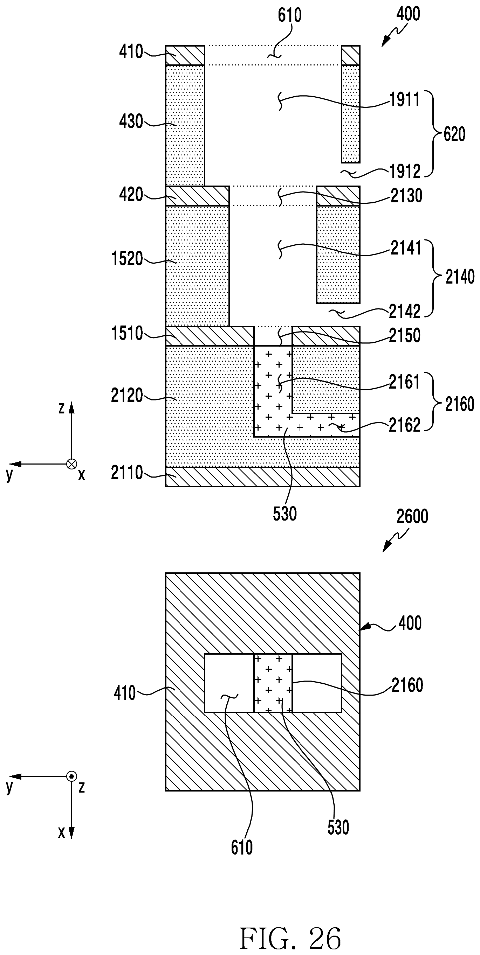

FIG. 26 illustrates a state in which the thermal interface material 530 is injected into an internal space of the printed circuit board assembly 400 defined by the third printed circuit board 1510, a fourth printed circuit board 2110, and a third interposer 2120. When a thermal interface material is injected into the internal space, the thermal interface material may be introduced into a sixth portion 2162 of the sixth through hole 2160 connected to the internal space. When the thermal interface material 530 is continuously injected, the thermal interface material may fill the fifth portion 2161 of the sixth through hole 2160 via the sixth portion 2162.

According to an embodiment, referring to a plan view 2600 in which the printed circuit board assembly 400 of FIG. 26 is viewed from above (e.g., the -z direction), the thermal interface material 530 in the fifth through hole 2150 or the fifth portion 2161 of the sixth through hole 2160 may be visible, when the first through hole 610 is viewed from above. Since the fifth through hole 2150 and the fifth portion 2161 of the sixth through hole 2160 have the narrowest width (e.g., the third width 2603 of FIG. 25), the thermal interface material 530 being filled in the internal space of the printed circuit board assembly 400 defined by the third printed circuit board 1510, the fourth printed circuit board 2110, and the third interposer 2120 may be inspected via a width of a portion filled with the thermal interface material 530.

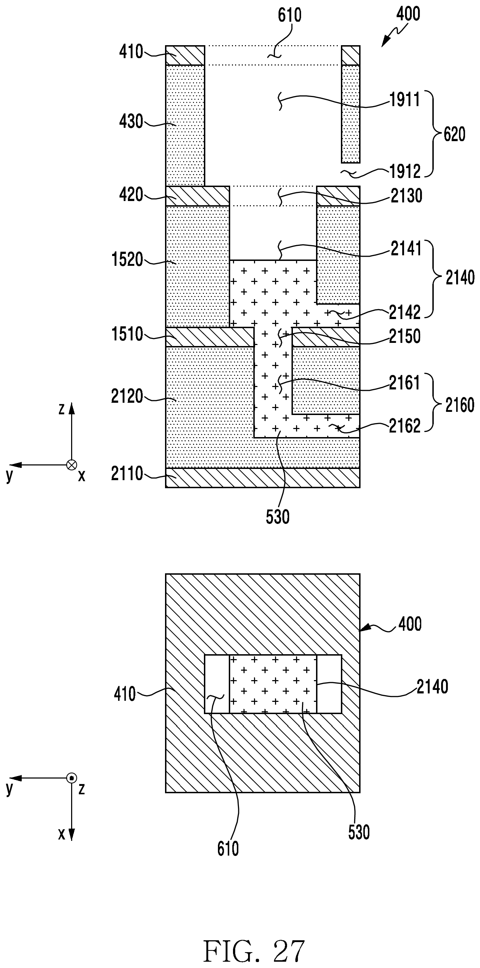

FIG. 27 illustrates a state in which the thermal interface material is injected into an internal space of the printed circuit board assembly 400 defined by the second printed circuit board 420, the third printed circuit board 1510, and a second interposer 1520. When the thermal interface material is injected into the internal space, the thermal interface material may be introduced into a fourth portion 2142 of the fourth through hole 2140 connected to the internal space. When the thermal interface material is continuously injected, the thermal interface material may fill the third portion 2141 of the fourth through hole 2140 via the fourth portion 2142.

According to an embodiment, referring to a plan view 2700 in which the printed circuit board assembly 400 of FIG. 27 is viewed from above (e.g., the -z direction), the thermal interface material 530 in the third through hole 2130 or the third portion 2141 of the fourth through hole 2140 may be visible, when the first through hole 610 is viewed from above. Since the third through hole 2130 and the third portion 2141 of the fourth through hole 2140 have a width (e.g., the second width 2602 of FIG. 25) wider than a width (e.g., the third width 2603 of FIG. 25) of the fourth through hole 2140 and the fifth portion 2161 of the sixth through hole 2160, the thermal interface material 530 being filled in the internal space of the printed circuit board assembly 400 defined by the second printed circuit board 420, the third printed circuit board 1510, and the second interposer 1520 may be inspected via a width of a portion filled with the thermal interface material 530.

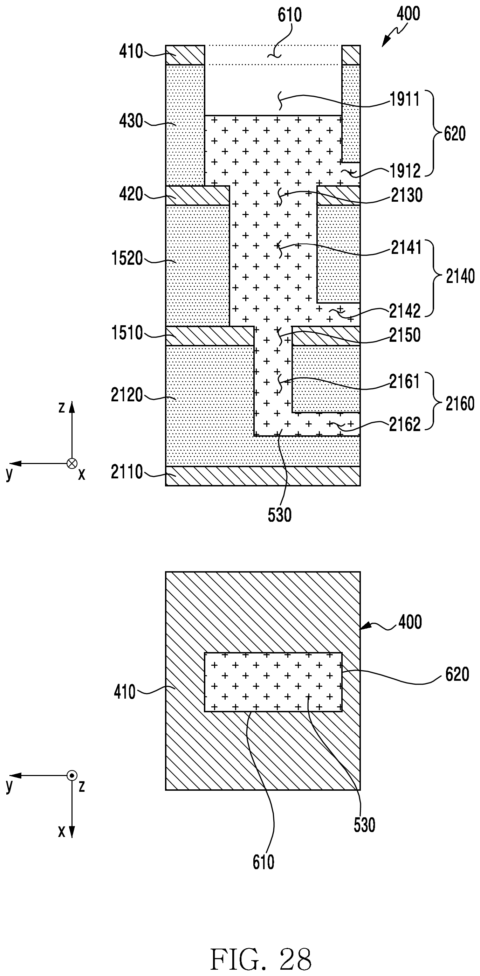

FIG. 28 illustrates a state in which the thermal interface material is injected into an internal space (e.g., the internal space 520 of FIG. 6) of the printed circuit board assembly 400 defined by the first printed circuit board 410, the second printed circuit board 420, and the first interposer 430. When the thermal interface material is injected into the internal space 520, the thermal interface material may be introduced into a second portion 1912 of the second through hole 620 connected to the internal space 520. When the thermal interface material is continuously injected, the thermal interface material may fill the first portion 1911 of the second through hole 620 via the second portion 1912.

According to an embodiment, referring to a plan view 2800 in which the printed circuit board assembly 400 of FIG. 28 is viewed from above (e.g., the -z direction), the thermal interface material 530 in the third through hole 2130 or the third portion 2141 of the fourth through hole 2140 may be visible, when the first through hole 610 is viewed from above. Since the first through hole 610 and the second portion 1912 of the second through hole 620 have the widest width (e.g., the first width 2601 of FIG. 25), the thermal interface material 530 being filled in the internal space 520 of the printed circuit board assembly 400 defined by the first printed circuit board 410, the second printed circuit board 420, and the first interposer 430 may be inspected via a width of a portion filled with the thermal interface material 530.

As described above, as the through holes are formed to have different widths, the through holes may be configured to function as an inspection hole (e.g., the inspection hole 402 of FIG. 4) for inspecting an injection state of the thermal interface material 530. In this case, even when the thermal interface materials 530 filled in each internal space 520 of the printed circuit board assembly 400 have substantially the same color, the injection state of the thermal interface material 530 may be inspected via a width difference.

The technical problems to be achieved in the present disclosure are not limited to those described above, and other technical problems not mentioned herein will be clearly understood by those having ordinary knowledge in the art to which the present disclosure belongs.

An electronic device 101 is described. The electronic device 101 may comprise a first printed circuit board (PCB) 410. The electronic device 101 may comprise a second PCB 420, spaced apart from the first PCB 410, disposed below the first PCB 410. The electronic device 101 may comprise an interposer 430, disposed between a first peripheral portion of the first PCB 410 and a second peripheral portion of the second PCB 420, configured to electrically connect the first PCB 410 and the second PCB 420. The electronic device 101 may comprise one or more electronic components 510 disposed in an internal space 520 that is defined by a rear side 412 of the first PCB 410, a front side 421 of the second PCB 420, and an inner side 431 of the interposer 430. The first PCB 410 may include (or define) a first through hole 610, extending from the rear side 412 of the first PCB 410 to a front side 411 of the first PCB 410, positioned in the first peripheral portion of the first PCB 410. The interposer 430 may include (or define) a second through hole 620 extending from a position on the inner side 431 to the rear side 412 of the first PCB 410 to be connected to the first through hole 610 of the first PCB 410.

For example, the interposer 430 may include a second conductive pad 632 corresponding to a first conductive pad 631 of the first PCB 410, and a solder 633, electrically connecting the first conductive pad 631 and the second conductive pad 632, coupling the interposer 430 and the first PCB 410.

For example, the second through hole 620 of the interposer 430 may be formed by omitting the second conductive pad 632 and/or the solder 633 in the portion of the interposer 430.

For example, the second through hole 620 may be formed by drilling the portion of the interposer 430.

For example, the first through hole 610 is connected to the internal space, via the second through hole 620.

For example, the first through hole 610 of the first PCB 410 may overlap the interposer 430, when the first PCB 410 is viewed from above.

For example, the first through hole 610 of the first PCB 410 and the second through hole 620 of the interposer 430 may be configured to function as a vent hole 403 through which air in the internal space 520 is discharged.

For example, the second PCB 420 may include (or define) a third through hole 1011, extending from the front side 421 of the second PCB 420 to a rear side 422 of the second PCB 420, positioned in the second peripheral portion of the second PCB 420. The interposer 430 may include (or define) a fourth through hole 1012 extending from another position on the inner side of the interposer to a front side 421 of the second PCB to be connected to the third through hole 1011.

For example, the electronic device 101 may further comprise a third PCB 1510 disposed below the second PCB 420. The electronic device 101 may further comprise another interposer 1520, disposed between the second peripheral portion of the second PCB 420 and a third peripheral portion of the third PCB 1510, configured to electrically connect the second PCB 420 and the third PCB 1510. The other interposer 1520 may include (or define) a fifth through hole 1532 connected to the fourth through hole 1012 of the interposer 430, via the third through hole 1011 of the second PCB 420.

For example, the second through hole 620 of the interposer 430 may include a first portion 1611 or 1911, aligned with the first through hole 610 of the first PCB 410, extending in a direction from the first PCB 410 toward the second PCB 420, and a second portion 1612 or 1912 extending from an end portion of the first portion 1611 or 1911 of the second through hole 620 to the inner side 431 of the interposer 430.

For example, the second through hole 620 of the interposer 430 may be configured to function as an injection hole 401 for injecting a thermal interface material 530 into the internal space 520.

For example, the electronic device 101 may further comprise a damper pad 550, disposed on the front side 411 of the first PCB 410 to cover the first through hole 610 of the first PCB 410, having a cut groove into which a nozzle 540 to inject the thermal interface material 530 is insertable.

For example, the second through hole 620 of the interposer 430 may be configured to function as an inspection hole 402 to be visible the thermal interface material 530 injected into the internal space 520.

For example, the electronic device 101 may further comprise a cap 404, disposed on the front side 411 of the first PCB 410 to cover the first through hole 610 of the first PCB 410, formed from a substantially transparent material.

For example, the second through hole 620 of the interposer 430 may extend from the inner side 431 of the interposer 430 defining the internal space 520 to an outer side 432 of the interposer 430 opposite to the inner side 431.

For example, the second through hole 620 of the interposer 430 may extend from the inner side 431 of the interposer 430 defining the internal space 520 to a position of the portion of the interposer 430 facing the first through hole 610 of the first PCB 410.

A PCB assembly 400 is described. The PCB assembly 400 may comprise a first printed circuit board (PCB) 410. The PCB assembly 400 may comprise a second PCB 420 disposed below the first PCB 410. The PCB assembly 400 may comprise an interposer 430, disposed between a first peripheral portion of the first PCB 410 and a second peripheral portion of the second PCB 420, configured to electrically connect the first PCB 410 and the second PCB 420. A rear side 412 of the first PCB 410, a front side 421 of the second PCB 420, and an inner side 431 of the interposer 430 may define an internal space 520 of the PCB assembly 400 for disposing one or more electronic components 510. The first PCB 410 may include a first through hole 610, extending from the rear side 412 of the first PCB 410 to a front side 411 of the first PCB 410, positioned in the first peripheral portion of the first PCB 410. The interposer 430 may include a second through hole 620, at least partially formed between the rear side 412 of the first PCB 410 and a portion of the interposer 430, connected to the first through hole 610. For example, the second through hole 620 may extend from a position on the inner side 431 of the interposer 430 to the rear side 412 of the first PCB 410 to be connected to the first through hole 610. The internal space of the PCB assembly defined by a rear side of the first PCB, a front side of the second PCB, and an inner side of the interposer is connected to outside of the PCB assembly, via the first through hole of the first PCB and the second through hole of the interposer.

For example, the interposer 430 may include a second conductive pad 632 corresponding to a first conductive pad 631 of the first PCB 410, and a solder 633, electrically connecting the first conductive pad 631 and the second conductive pad 632, coupling the interposer 430 and the first PCB 410. The second through hole 620 of the interposer 430 may be formed by omitting the second conductive pad 632 and/or the solder 633 in the portion of the interposer 430.

For example, the first through hole 610 of the first PCB 410 may overlap the interposer 430, when the first PCB 410 is viewed from above.

For example, the second through hole 620 of the interposer 430 may extend from the inner side 431 of the interposer 430 defining the internal space 520 to an outer side 432 of the interposer 430.

For example, the second PCB 420 may further include a third through hole 1011, extending from the front side 421 of the second PCB 420 to a rear side 422 of the second PCB 420, positioned in the second peripheral portion of the second PCB. The interposer 430 may further include a fourth through hole 1012, formed between the front side 421 of the second PCB 420 and another portion of the interposer 430, connected to the third through hole 1011.

According to a first example of the present disclosure, there is provided a printed circuit board, PCB, assembly or an electronic device comprising: a first PCB; a second PCB spaced apart from the first PCB; a first interposer disposed between a first peripheral portion of the first PCB and a second peripheral portion of the second PCB and configured to electrically connect the first PCB and the second PCB; and wherein a rear side of the first PCB, a front side of the second PCB, and an inner side of the first interposer define an internal space, wherein a first through hole is formed in the first peripheral portion of the first PCB, the first through hole configured to extend from a front side of the first PCB to the rear side of the first PCB, and wherein a second through hole is formed in the first interposer, the second through hole configured to extend from a first position on the inner side of the first interposer to the rear side of the first PCB to connect to the first through hole.

According to a second example, there is provided the PCB assembly or the electronic device of the first example, wherein the first interposer includes: a second conductive pad corresponding to a first conductive pad of the first PCB, and a solder configured to electrically connect the first conductive pad and the second conductive pad and couple the first interposer and the first PCB; and wherein the second through hole is formed by omitting or removing the second conductive pad and the solder in the portion of the first interposer.

According to a third example, there is provided the PCB assembly or the electronic device of the first example, wherein the second through hole is formed by drilling the portion of the first interposer.

According to a fourth example, there is provided the PCB assembly or the electronic device of any one of the first example to the third example, wherein the first through hole and the second through hole are configured to function as a vent hole through which air from the internal space is discharged.

According to a fifth example, there is provided the PCB assembly or the electronic device of any one of the first example to the fourth example, wherein a third through hole is formed in the second peripheral portion of the second PCB, the third through hole configured to extend from the front side of the second PCB to a rear side of the second PCB, and wherein a fourth through hole is formed in the first interposer, the fourth through hole configured to extend from a second position on the inner side of the first interposer to the front side of the second PCB to connect to the third through hole of the second PCB.

According to a sixth example, there is provided the PCB assembly or the electronic device of the fifth example, further comprising: a third PCB disposed; and a second interposer disposed between the second peripheral portion of the second PCB and a third peripheral portion of the third PCB and configured to electrically connect the second PCB and the third PCB, and wherein a fifth through hole is formed in the second interposer to connect to the fourth through hole via the third through hole.

According to a seventh example, there is provided the PCB assembly or the electronic device of any one of the first example to the third example, wherein the second through hole includes: a first portion configured to align with the first through hole and extend in a first direction from the first PCB toward the second PCB, and a second portion configured to extend from an end portion of the first portion of the second through hole to the first position on the inner side of the first interposer.

According to an eighth example, there is provided the PCB assembly or the electronic device of the seventh example, wherein the second portion comprises a first sub-portion, a second sub-portion and a third sub-portion; wherein: the first sub-portion is configured to extend from first position on the inner side of the first interposer in a second direction perpendicular to the first direction to connect with the second sub-portion, the second sub-portion is configured to extend from the first sub-portion in the first direction to connect with the third sub-portion, and the third sub-portion is configured to extend from the second sub-portion in the second direction to connect with the end portion of the first portion.

According to a ninth example, there is provided the PCB assembly or the electronic device of the seventh example or the eighth example, wherein the second through hole is configured to function as an injection hole for injecting a thermal interface material into the internal space.

According to a tenth example, there is provided the PCB assembly or the electronic device of the ninth example, further comprising a damper pad disposed on the front side of the first PCB to cover the first through hole and configured to have a cut groove into which a nozzle to inject the thermal interface material is insertable.

According to an eleventh example, there is provided the PCB assembly or the electronic device of the seventh example or the eighth example, wherein the second through hole is configured to function as an inspection hole for inspecting a thermal interface material injected into the internal space.

According to a twelfth example, there is provided the PCB assembly or the electronic device of the eleventh example, further comprising a cap disposed on the front side of the first PCB to cover the first through hole of the first PCB and formed from a transparent material.

According to a thirteenth example, there is provided the PCB assembly or the electronic device of any one of the first example to the sixth example, wherein the second through hole is configured to extend from the inner side of the interposer to an outer side of the first interposer.

According to a fourteenth example, there is provided the PCB assembly or the electronic device of any one of the first example to the thirteenth example, wherein one or more electronic components are disposed in the internal space; and wherein heat generated by the one or more electronic components is vented through the second through hole and the first through hole.

According to a fifteenth example, there is provided the PCB assembly of any one of the first example to the fourteenth example, wherein the PCB assembly is included in an electronic device.

The effects that may be obtained from the present disclosure are not limited to those described above, and any other effects not mentioned herein will be clearly understood by those having ordinary knowledge in the art to which the present disclosure belongs.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a first printed circuit board (PCB);
a second PCB, spaced apart from the first PCB;
an interposer, disposed between a first peripheral portion of the first PCB and a second peripheral portion of the second PCB, configured to electrically connect the first PCB and the second PCB; and
one or more electronic components disposed in an internal space that is defined by a rear side of the first PCB, a front side of the second PCB, and an inner side of the interposer,
wherein the first PCB defines a first through hole, extending from a front side of the first PCB to the rear side of the first PCB, positioned in the first peripheral portion of the first PCB, and
wherein the interposer defines a second through hole extending from a position on the inner side of the interposer to the rear side of the first PCB to be connected to the first through hole of the first PCB.

2. The electronic device of claim 1,
wherein the interposer includes:
a second conductive pad corresponding to a first conductive pad of the first PCB, and
a solder configured to electrically connect the first conductive pad and the second conductive pad, coupling the interposer and the first PCB, and
wherein the second through hole of the interposer is formed by omitting or removing the second conductive pad and the solder in the portion of the interposer.

3. The electronic device of claim 1,
wherein the first through hole of the first PCB is connected to the internal space via the second through hole of the interposer.

4. The electronic device of claim 1,
wherein the second through hole of the interposer is formed by drilling a portion of the interposer.

5. The electronic device of claim 1,
wherein the first through hole of the first PCB and the second through hole of the interposer are configured to function as a vent hole through which air from the internal space is discharged.

6. The electronic device of claim 1,
wherein the second PCB defines a third through hole, extending from the front side of the second PCB to a rear side of the second PCB, positioned in the second peripheral portion of the second PCB, and
wherein the interposer defines a fourth through hole extending from another position on the inner side of the interposer to a front side of the second PCB to be connected to the third through hole.

7. The electronic device of claim 6, further comprising:
a third PCB, wherein the second PCB is positioned between the first PCB and the third PCB; and
another interposer, disposed between the second peripheral portion of the second PCB and a third peripheral portion of the third PCB, configured to electrically connect the second PCB and the third PCB, and
wherein the other interposer defines a fifth through hole connected to the fourth through hole of the interposer, via the third through hole of the second PCB.

8. The electronic device of claim 1,
wherein the second through hole of the interposer includes:
a first portion, aligned with the first through hole of the first PCB, extending in a direction from the first PCB toward the second PCB, and
a second portion extending from an end portion of the first portion of the second through hole to the inner side of the interposer.

9. The electronic device of claim 8,
wherein the second through hole of the interposer is configured to function as an injection hole for injecting a thermal interface material into the internal space.

10. The electronic device of claim 9, further comprising a damper pad, disposed on the front side of the first PCB to cover the first through hole of the first PCB, having a cut groove into which a nozzle to inject the thermal interface material is insertable.

11. The electronic device of claim 8,
wherein the second through hole of the interposer is configured to function as an inspection hole for inspecting a thermal interface material injected into the internal space.

12. The electronic device of claim 11, further comprising a cap, disposed on the front side of the first PCB to cover the first through hole of the first PCB, formed from a substantially transparent material.

13. The electronic device of claim 1,
wherein the second through hole of the interposer extends from the inner side of the interposer to an outer side of the interposer opposite to the inner side of the interrposer.

14. The electronic device of claim 1,
wherein the second through hole is at least partially bent.

15. A PCB assembly comprising:
a first printed circuit board (PCB);
a second PCB spaced apart from the first PCB; and
an interposer, disposed between a first peripheral portion of the first PCB and a second peripheral portion of the second PCB, configured to electrically connect the first PCB and the second PCB,
wherein the first PCB defines a first through hole, extending from a front side of the first PCB to the rear side of the first PCB, positioned in the first peripheral portion of the first PCB,
wherein the interposer defines a second through hole extending from a position on the inner side of the interposer to the rear side of the first PCB to be connected to the first through hole of the first PCB, and
wherein an internal space of the PCB assembly defined by a rear side of the first PCB, a front side of the second PCB, and an inner side of the interposer is connected to outside of the PCB assembly, via the first through hole of the first PCB and the second through hole of the interposer.
